# EUROPEAN PATENT SPECIFICATION

(11) **EP 1 690 279 B1**
(45) Date of publication and mention of the grant of the patent: **21.03.2012**
(21) Application number: 04810268.5
(22) Date of filing: 04.11.2004
(51) Int. Cl.: C23C 14/00, C23C 14/35, C23C 14/54, C23C 14/34, H01J 37/34

(54) **PLASMA SOURCE WITH SEGMENTED MAGNETRON CATHODE**
PLASMAQUELLE MIT SEGMENTIERTER MAGNETRON-KATHODE
SOURCE DE PLASMA AVEC CATHODE DE MAGNETRON SEGMENTEE

(30) Priority: 19.11.2003 US 481671 P; 13.08.2004 US 710946
(43) Date of publication of application: 16.08.2006
(73) Proprietor: Zond, Inc., Mansfield, MA 02048 (US)
(72) Inventor: CHISTYAKOV, Roman, Mansfield, MA 02048 (US)
(74) Representative: Jackson, Robert Patrick
(86) International application number: PCT/US2004/036636
(87) International publication number: WO 2005/052979

(56) References cited:
- EP-A- 1 046 727
- EP-A- 1 146 139
- US-B1- 6 197 165

## Description

Physical Vapor Deposition (PVD) is a plasma process that is commonly used In the manufacturing of many products, such as semiconductors, flat panel displays, and optical devices. Physical vapor deposition causes ions in a plasma to dislodge or sputter material from a target. The dislodged or sputtered target material is then deposited on a surface of a workpiece to form a thin film.

Independently controlling the uniformity of the sputtered film and the density of the plasma generated during PVD becomes more difficult as the size of the workpiece Increases. In magnetron sputtering, large targets are typically required to sputter coat large workpieces. However, processing large workpieces can result in problems, such as poor target utilization, target cooling problems, and non-uniform coating of the workpleces.

Complex rotating magnet configurations have been used to improve plasma uniformity and to prevent non-uniform erosion of the target. In some systems, workpieces are moved relative to the plasma in order to increase the uniformity of the sputtered film. However, moving the magnets and/or the workpieces can result in a lower deposition rate. In other systems, the power applied to the target is Increased to increase the deposition rate. However, increasing the power applied to the target can result in undesirable target heating. Compensating for temperature increases associated with increasing the power applied to the target by cooling the target in the deposition system increases the cost and complexity of the deposition system.

US 6197165 discloses a plasma source comprising: a power supply; a chamber for containing a feed gas; an anode that is positioned in the chamber; a segmented magnetron cathode comprising a plurality of magnetron cathode segments that are positioned in the chamber proximate to the anode, each of the plurality of magnetron cathode segments being electrically isolated from each of the other magnetron cathode segments. The present invention is characterised by a switch having an electrical input and a plurality of electrical outputs, a respective one of the plurality of electrical outputs being electrically connected to a respective one of the plurality of magnetron cathode segments; and in that the power supply has an electrical output that is electrically connected to the electrical input of the switch, the power supply being arranged to generate a train of voltage pulses that ignites a plasma from the feed gas, individual voltage pulses in the train of voltage pulses being routed by the switch in a predetermined sequence to at least two of the plurality of magnetron cathode segments.

The above and further advantages of this invention may be better understood by referring to the following description in conjunction with the accompanying drawings, in which like numerals indicate like structural elements and features in various figures. The drawings are not necessarily to scale, emphasis instead being placed upon illustrating the principles of the invention.
FIG. 1 illustrates a diagram of a plasma source including a segmented magnetron cathode according to one embodiment of the invention.
FIG. 2A illustrates a cross-sectional view of the plasma source including the segmented magnetron cathode of FIG. 1.
FIG. 2B illustrates a cross-sectional view of a plasma source including the segmented magnetron cathode of FIG. 1 having an alternative magnet assembly.
FIG. 2C illustrates a cross-sectional view of a plasma source including the segmented magnetron cathode of FIG. 1 with a magnet assembly having an unbalanced magnet configuration.
FIG. 2D illustrates a cross-sectional view of a plasma source including a segmented magnetron cathode that can be used for reactive sputtering.
FIG. 3A through FIG. 3I are graphical representations of voltage pulse trains that can be used to energize the plasma source of FIG. 1.
FIG. 4 is a flowchart of a method for generating a plasma according to one embodiment of the invention.
FIG. 5 is a table of exemplary voltage pulse parameters that can be associated with particular magnetron cathode segments.

FIG. 6 illustrates a cross-sectional view of a plasma source including a segmented magnetron cathode according to one embodiment of the invention.

FIG. 7 illustrates a diagram of a plasma source including a segmented cathode having an oval shape according to one embodiment of the Invention.

FIG. 8 illustrates a diagram of a plasma source including a segmented magnetron cathode in the shape of a hollow cathode magnetron (HCM) according to one embodiment of the invention.

FIG. 9 illustrates a diagram of a plasma source including a segmented magnetron cathode in the shape of a conical cathode magnetron according to one embodiment of the invention.

FIG. 10 illustrates a diagram of a plasma source including a segmented magnetron cathode including a plurality of small circular cathode segments according to one embodiment of the invention.

FIG. 11 illustrates a diagram of a plasma source including a segmented magnetron cathode including a plurality of concentric cathode segments according to one embodiment of the invention.

FIGs. 12A-12D illustrate four segmented cathodes having various shapes according to the invention.
Preferred embodiments of the invention will now be described, by way of example only, and with reference to the accompanying drawings.

The present invention relates to plasma systems having multiple or segmented magnetron cathodes instead of one single magnetron cathode. A plasma generated by a plasma system having a segmented magnetron cathode design according to the present invention creates a more uniform coating on a substrate at given level of plasma density than a plasma that is generated by a known plasma system having a single magnetron cathode geometry. The uniformity of a thin film generated with a plasma system having multiple magnetron cathode segments is relatively high because each of the multiple magnetron cathode segments can independently control a film thickness in a small localized area of the workpiece in order to generate a more uniform coating on the entire workpiece. Increasing the number of magnetron cathode segments increases the control over the coating thickness. The sputtered material generated by the segmented magnetron cathode can also be directed to different locations in the chamber depending on the geometry of the segmented magnetron cathode.

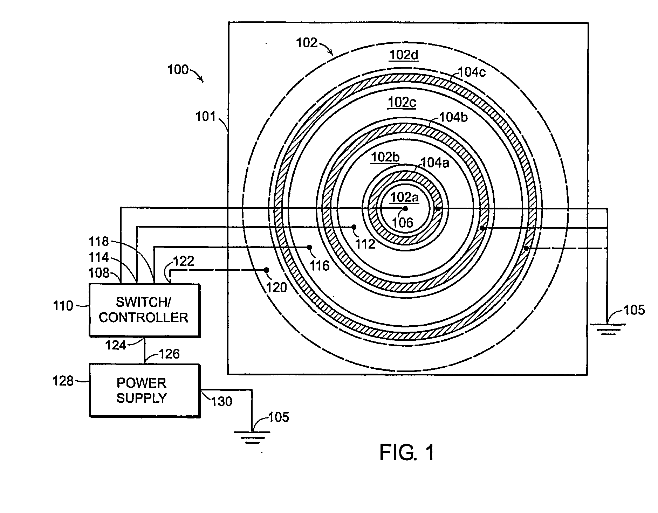

FIG. 1 illustrates a diagram of a plasma source 100 including a segmented magnetron cathode 102 according to one embodiment of the invention. The segmented magnetron cathode 102 is located within a chamber 101 that confines a feed gas. The segmented magnetron cathode 102 includes a plurality of magnetron cathode segments. The segmented magnetron cathode 102 according to the present invention can be embodied in many different geometries. For example, the segmented magnetron cathode 1 02 of the present invention can include magnetron cathode segments that all have equal surface area. Alternatively, the segmented magnetron cathode of the present invention can include magnetron cathode segments that have different surface areas. The magnetic field associated with the segmented magnetron cathode can have any geometry and any strength depending upon the particular application. In addition, the segmented magnetron cathode can include a water cooling system (not shown) to control the temperature of the sputtering target.

The segmented magnetron cathode 102 includes a first 102a, a second 102b, and a third 102c magnetron cathode segment. The segmented magnetron cathode 102 can also include a fourth magnetron cathode segment 1 02d. Additional magnetron cathode segments can be added as necessary depending on the specific plasma process, the size of the workpiece to be processed, and/or the desired uniformity of the coating. The magnetron cathode segments 102a-d are typically electrically isolated from each other. In one embodiment, the segmented magnetron cathode 102 includes target material for sputtering. The target material can be integrated into or fixed onto each magnetron cathode segment 102a-d.

The plasma source 100 also includes at least one anode that is positioned proximate to the plurality of magnetron cathode segments 102a, 1 02b, and 1 02c in the chamber 101. In one embodiment, the plasma source 100 includes a plurality of anode sections 104a, 1 04b. The plurality of anode sections 104a, 104b are positioned adjacent to the magnetron cathode segments 102a, 102b, 102c. An additional anode section 104c is positioned adjacent to the optional fourth magnetron cathode segment 102d. In one embodiment, the anode sections 104a, 104b, 104c are coupled to ground 105. In other embodiments, the anode sections 104a, 104b, 104c are coupled to a positive terminal of a power supply. Additional anodes and magnetron cathode segments can be added to form a larger plasma source for processing large workpieces, such as 300mm wafers, architectural workpieces, and flat panel displays.

An input 106 of the first magnetron cathode segment 102a is coupled to a first output 108 of a switch 110. An input 112 of the second magnetron cathode segment 102b is coupled to a second output 114 of the switch 110. An input 116 of the third magnetron cathode segment 102c is coupled to a third output 118 of the switch 110. An input 120 of the optional fourth magnetron cathode segment 102d is coupled to a fourth output 122 of the switch 110. The switch 110 can be an any type of electrical or mechanical switch that has the required response time, voltage capacity, and current capacity. In one embodiment, the switch 110 is programmable via a computer or processor. The switch 110 can include one or more insulated gate bipolar transistors (IGBTs). In some embodiments (not shown), at least one output 108, 114, 118, 122 of the switch 110 can be coupled to more than one magnetron cathode segment 102a-d in the segmented magnetron cathode 102. The switch 110 can be configured to apply one or more voltage pulses to each of the magnetron cathode segments 102a-d in a predetermined sequence. This allows a single pulsed DC power supply to apply independent voltage pulses to each magnetron cathode segment 102a-d.

An input 124 of the switch 110 is coupled to a first output 126 of a power supply 128. A second output 130 of the power supply 128 is coupled to ground 105. The power supply 128 can be a pulsed power supply, a switched DC power supply, an alternating current (AC) power supply, or a radio-frequency (RF) power supply. In one embodiment, the power supply 128 generates a train of voltage pulses that are routed by the switch 110 to the magnetron cathode segments 102a-d. The switch 110 can include a controller that controls the sequence of the individual voltage pulses in the train of voltage pulses that are routed to the magnetron cathode segments 102a-d. Alternatively, an external controller (not shown) can be coupled between the power supply 128 and the switch 110 to control the the sequence of the voltage pulses in the train of voltage pulses that are routed to the magnetron cathode segments 102a-d. In some embodiments, the controller is a processor or a computer.

In one embodiment, the plasma source 100 is scalable to process large workpieces. In this embodiment, the power supply 128 is a single high-power pulsed direct current (DC) power supply. The single high-power pulsed DC power supply generates a high-density plasma with a power level between about 5kW and 1,000kW during each pulse. In one embodiment, the single pulsed DC power supply generates a high-density plasma with a power level that is between about 50kW and 1,000kW during each pulse depending on the surface area of each magnetron cathode segment 102a-d of the segmented magnetron cathode 102. The power level is chosen based on the surface area of the particular magnetron cathode segment 102a-d to achieve a specific result. Thus, a power supply that generates a moderate amount of power during the pulse can be used in a plasma source 100 according to the present invention to generate the high-density plasma.

A power supply that generates a moderate amount of power during the pulse can be used in the plasma source 100 to generate a high-density plasma. A pulsed power supply having an extremely high-power output would be required in some systems in order to generate a comparable power density on a single magnetron cathode. However, the duty cycle of the pulsed power supply used in the plasma source 100 is typically higher than the duty cycle for a power supply used for a single magnetron cathode in order to maintain the same average power.

The magnetron size of the segmented magnetron of the present invention can be scaled up while maintaining the same power density as a small magnetron. This is achieved by segmenting the magnetron into a plurality of magnetron segments. The duty cycle of the pulsed power supply is increased in order to apply the same average power. This approach allows the segmented magnetron cathode 102 to operate with a moderate power level and a moderate current level. The segmented magnetron cathode 102 can use the same pulsed power supply 128 for a small or a large area magnetron in order to generate the same plasma density during the pulse, although the duty cycle is changed in order to maintain the same average power.

For example, if the magnetron has an area S1, and the power applied during the pulse is P1, then the power density can be expressed as P1 /S1. Assuming that the power supply has duty cycle of about ten percent, then the average power that is applied to the magnetron is about 0.1 P1. If another magnetron has an area 451, then in order to keep the same power density and average power, the power supply applies a power of 4P1 during the pulse at the same duty cycle. In the case of a segmented magnetron cathode that consists of four magnetron cathode segments each with area S1, the same power P1 can be applied to each of the four magnetron segments. In order to apply the same average power to the segmented magnetron, the duty cycle of the power supply is increased from ten percent to forty percent. In this case, the switch can route pulses to the different magnetron segments to provide the same power density and average power. The size of the magnetron can be increased until the duty cycle of the power supply reaches almost one hundred percent. At that point, the power level during the pulse is increased and a compromise is made between modifying the pulse power level and the duty cycle.

The number of magnetron cathode segments 102a-d, the duty cycle, and the maximum power of the pulsed power supply 128 can be chosen for a particular application. For example, a smaller number of magnetron cathode segments 102a-d in the segmented magnetron cathode 102 can require a high-power pulsed power supply having a low duty cycle while a larger number of magnetron cathode segments 102a-d can require a lower-power pulsed power supply having a higher duty cycle in order to generate a similar power density and average power.

In one embodiment, the pulse width of the voltage pulses generated by the power supply 128 is between about 50microseconds and 10seconds. The duty cycle of the voltage pulses generated by the power supply 128 can be anywhere between a few percent and ninety-nine percent. In one embodiment, the duty cycle is about twenty percent. The duty cycle of the power supply 128 depends on the number of magnetron cathode segments 102a-d in the segmented magnetron cathode 102 and the time required for the switch 110 to operate. The repetition rate of the voltage pulses generated by the power supply 128 can be between about 4Hz and 1000Hz. In one embodiment, the repetition rate of the voltage pulses is at about 200Hz. Thus, for a pulse width of 1,000 µ sec, the time period between pulses for a repetition rate of 200Hz is approximately 4,020 µ sec. The switch 110 redirects the voltage pulses to the various magnetron cathode segments 102a-d during the time period between pulses.

The average power generated by the power supply 128 is between about 5kW and 100kW. However, the peak power generated by the power supply can be much greater. For example, the peak power is about 330kW for a plasma having a discharge current of 600A that is generated with voltage pulses having a magnitude of 550V. The power supply 128 generates an average power of about 20kW for voltage pulses having a pulse width of 1,000 µ sec and a repetition rate of 200Hz.

The power supply 128 can vary the rise time of the voltage pulse, the magnitude, the pulse duration, the fall time, the frequency, and the pulse shape of the voltage pulses depending on the desired parameters of the plasma. The term "pulse shape" is defined herein to mean the actual shape of the pulse, which can be a complex shape that includes multiple rise times, fall times, and peaks. A pulse train generated by the power supply 128 can include voltage pulses with different voltage levels and/or different pulse widths. The switch 110 can route one or more of the voltage pulses to each of the magnetron cathode segments 102a-d in a predetermined sequence depending on several factors, such as the size of the segmented magnetron cathode 102, the number of magnetron cathode segments 102a-d, and the desired uniformity of the coating and density of the plasma. Each individual voltage pulse in the train of voltage pulses can have a different shape including different pulse widths, number of rise times and/or different amplitudes. The particular rise times and/or amplitudes of the voltage pulses can be selected to achieve a desired result, such as a desired sputtered metal ion density and/or a desired uniformity of a coating.

The segmented magnetron cathode 102 reduces cathode heating because voltage pulses are independently applied to each of the magnetron cathode segments 102a-d. Thus, when a voltage pulse is applied to one of the magnetron cathode segments 102a-d, the heat previously generated on the other magnetron cathode segments 102a-d dissipates. Therefore, the segmented magnetron cathode 102 can operate with relatively high peak plasma densities by permitting higher voltage pulses to be applied to each of the magnetron cathode segments 102a-d. Thus, the segmented magnetron cathode 102 can operate with relatively high overall power applied to the plasma without overheating the individual magnetron cathode segments 102a-d. In some embodiments, the uniformity of the thin film deposited by the segmented magnetron cathode can be optimized by adjusting the shape, frequency, duration, and sequence of the voltage pulses for the various magnetron cathode segments.

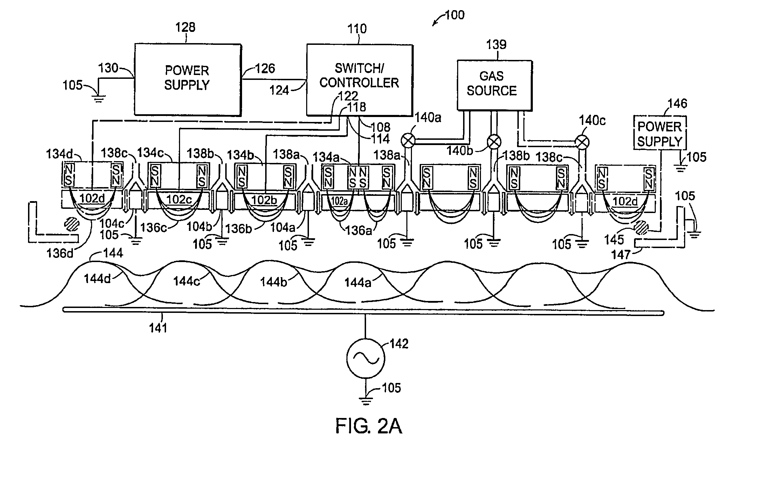

FIG. 2A illustrates a cross-sectional view of the plasma source 100 including the segmented magnetron cathode 102 of FIG. 1. The plasma source 100 includes at least one magnet assembly 134a positioned adjacent to the first magnetron cathode segment 1 02a. Additional magnet assemblies 134b, 134c, 134d are positioned adjacent to the other respective magnetron cathode segments 102b, 102c, 102d. The magnet assembly 134a creates a magnetic field 136a proximate to the first magnetron cathode segment 102a. The magnetic field 1 36a traps electrons in the plasma proximate to the first magnetron cathode segment 102a. Additional magnetic fields 136b, 136c, and 136d trap electrons in the plasma proximate to the their respective magnetron cathode segments 102b-d. The strength of each magnetic field 136a-d generated by each magnet assembly 134a-d can vary depending on the desired properties of the coating, such as the desired coating uniformity.

One or more of the magnetic assemblies 134a-d can generate unbalanced magnetic fields. The term "unbalanced magnetic field" is defined herein as a magnetic field that includes non-terminating magnetic field lines. For example, unbalanced magnetic fields can be generated by magnets having different pole strengths. Unbalanced magnetic fields can increase the ionization rate of atoms sputtered from the segmented magnetron cathode 102 in an ionized physical vapor deposition (I-PVD) process. The unbalanced magnetic field can also increase the ion density of the ionized sputtered atoms. In one embodiment, the sputtered atoms are metal atoms and the unbalanced magnetic field increases the ionization rate of the sputtered metal atoms to create a high density of metal ions.

A first 138a, a second 1 38b, and a third plurality of feed gas injectors 138c can be positioned to inject feed gas between the corresponding cathode segments 102a-d and anode sections 104a-c. Each of the plurality of feed gas injectors 138a-c can be positioned to inject feed gas so that a desired uniformly is achieved around the circumference of each respective magnetron cathode segment 102a-d.

The pluralities of feed gas injectors 138a-c are coupled to one or more gas sources 139 through gas valves 140a-c. The gas source 1 39 can include non-reactive gases, reactive gases, or a mixture of non-reactive and reactive gases. The gas valves 140a-c can precisely meter feed gas to each of the pluralities of feed gas injectors 138a-c in a controlled sequence. In one embodiment, the gas valves 140a-c can pulse feed gas to the each of the pluralities of feed gas injectors 138a-c. In one embodiment, an excited atom source (not shown) supplies excited atoms through the feed gas injectors 138a-c.

A substrate 1 41 or workpiece is positioned adjacent to the segmented magnetron cathode 102. Th e potential of the substrate 141 can be at a floating potential, can be biased to a predetermined potential, or can be coupled to ground. In one embodiment, the substrate 141 is coupled to an radio-frequency (RF) power supply 142. The plasma source 100 can be used to sputter deposit a coating on the substrate 141. In this embodiment, each of the magnetron cathode segments 102a-d includes target material. The power supply 128 generates the train of voltage pulses and the switch 110 routes the individual voltage pulses in the train of voltage pulses to the various magnetron cathode segments 1 02a-d in a predetermined sequence. The target material from each of the magnetron cathode segments 102a-d sputter coats the substrate 14 to generate coatings that are represented by thickness profiles 144a-d that correspond to the thickness of the coating material that is deposited by each of the cathode segments 102a-d.

In one embodiment, an optional ring-shaped pre-ionizing electrode 145 is positioned proximate to the segmented magnetron cathode 102. The pre-ionizing electrode 145 is coupled to an output of a power supply 146. Another output of the power supply 146 is coupled to ground 105. For example, the power supply 146 can be a RF power supply, a DC power supply, a pulsed power supply, or an AC power supply. A grounded electrode 147 is positioned proximate to the pre-ionizing electrode 145 so that the power supply 146 can generate a plasma discharge between the grounded electrode 147 and the pre-ionizing electrode 145.

The discharge can ignite a feed gas to create a weakly-ionized plasma proximate to the segmented magnetron cathode 102. The discharge can also create an additional amount of electrons inside the chamber without igniting the discharge such as by emitting electrons under high temperature due to electrical current flowing through pre-ionizing electrode. The additional electrons can reduce the Ignition voltage from the pulsed power supply that is required to create a weakly-ionized plasma. The properties of the discharge depend on the design of the magnetic field and the position of the pre-ionizing electrode. Generating a weakly-ionized plasma using a pre-ionizing electrode is described in co-pending U.S. Patent Application No. 10/065,629, entitled Methods and Apparatus for Generating High-Density Plasma, which is assigned to the present assignee.

The rise time, the amplitude, the pulse duration, the fall time, and the pulse shape of each voltage pulse in the train of voltage pulses generated by the power supply 128 as well as the sequence with which the voltage pulses are routed by the switch 110 can be adjusted to improve the homogeneity of the thickness profiles 144a-d, thereby improving the coating uniformity 144 across the substrate 141. Also, selecting the parameters of the voltage pulses can increase the amount of sputtered material arriving on the substrate in the form of ions. The amount of sputtered material arriving on the substrate can be adjusted independently from an adjustment of the coating uniformity. In one embodiment, modifying the rise time of the voltage pulse can be used to adjust the amount of sputtered metal ions and modifying the pulse duration can be used to control the film uniformity. A highly uniform coating generated by ions of sputtered material can substantially fill high-aspect ratio contacts, trenches, and vias, for example. Therefore, the plasma source 100 can be used for ionized physical vapor deposition (I-PVD). Also, since the deposition rate and the plasma density from each magnetron cathode segment 102a-d can be adjusted independently, a coating can be uniformly deposited across the entire surface of the substrate 141. in one embodiment, the segmented magnetron cathode 102 including the target material is about the same size as the substrate 141. Reducing the size of the magnetron cathode reduces the overall size of the plasma source 100 and the overall cost of the system.

The switch 110 can also route the voltage pulses to the various magnetron cathode segments 102a-d to create particular thickness profiles across the surface of the substrate 141. For example, a particular thickness profile can include a film that is thinner in the center of the substrate 141 than on the outer edge of the substrate 141.

The plasma source 100 can also be used to uniformly etch the substrate 141. The plasma generated by the segmented magnetron cathode 102 can be highly uniform across the surface of the substrate 141. The plasma source 100 can also be used for ionized physical vapor deposition (I-PVD), reactive sputtering, compound sputtering, reactive ion etch (RIE), ion beam processing, or any other plasma process.

The plasma source 100 can be used to generate a high-density plasma for I-PVD processing. For example, the plasma source 100 can be used to generate a high-density plasma for I-PVD of copper ions in order to efficiently sputter coat high-aspect ratio structures on the substrate 141 with or without using a RF bias on the substrate 141. The high-density plasma generated by the segmented magnetron cathode 102 sputters copper atoms from a copper target. The copper atoms collide with electrons in the high-density plasma creating a multitude of copper ions.

The plasma generates a so-called "dark space" between the edge of the plasma and the surface of an electrically floating substrate 141. The high-density plasma generated by the segmented magnetron cathode 102 has a high electron temperature which creates a negative bias on the substrate 104. The negative bias attracts the copper ions and accelerates the copper ions through the dark space towards the substrate 141. An electric field develops between the positively charged plasma and the negatively charged substrate 141. The copper ions are accelerated along electric field lines and uniformly sputter coat the high-aspect-ratio structures on the substrate 141. A RF bias can be applied to the substrate 141 to further improve the uniformity of the coating process or to sputter coat high-aspect-ratio features.

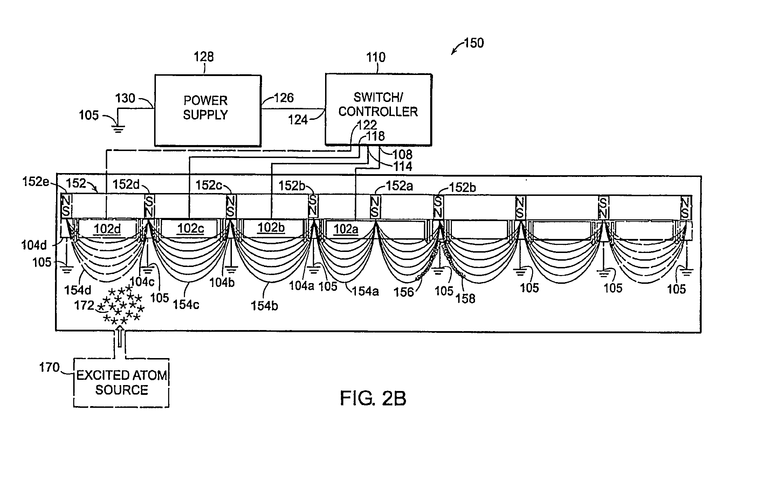

FIG. 2B illustrates a cross-sectional view of a plasma source 150 including the segmented magnetron cathode 102 of FIG. 1 having an alternative magnet assembly 152. The magnet assembly 152 includes at least one magnet 152a that is positioned adjacent to the first mag netron cathode segment 102a. Additional magnets 152b-e are positioned adjacent to each respective anode section 104a-d. In one embodiment, the magnets 152a-e have magnetic field strengths that result in an unbalanced magnetic field. Generating an unbalanced magnetic field can increase the density of the plasma proximate to a substrate (not shown in FIG. 2B) and thus increase the rate of ionization of metal atoms and the density of metal ions in an I-PVD process.

The magnet 1 52a creates a magnetic field 154a proximate to the first magnetron cathode segment 102a. The magnetic field 1 54a traps electrons in the plasma proximate to the first magnetron cathode segment 102a. Additional magnetic fields 1 54b-d trap electrons in the plasma proximate to the other respective magnetron cathode segments 102b-d. The strength of each magnetic field 1 54a-d generated by each magnet 1 52a-d can vary depending on the desired properties of the coating, such as the desired coating uniformity at the desired plasma density level.

The first output 126 of the power supply 128 is coupled to the input 124 of the switch 110. The first output 108 of the switch 110 is coupled to the first magnetron cathode segment 102a. The second output 114 of the switch 110 is coupled to the second magnetron cathode segment 1 02b. The third output 118 of the switch 110 is coupled to the third magnetron cathode segment 102c. The fourth output 122 of the switch 110 is coupled to the fourth magnetron cathode segment 102d.

The second output 130 of the power supply 128 and the anode sections 104a-d are coupled to ground 1 05. In other embodiments, the second output 130 of the power supply 128 is coupled to the anodes 104a-d and the anodes 104a-d are biased at a positive voltage.

Magnetic coupling of the magnetron cathode segments 102a-d is achieved by positioning the magnets 1 52a-e between the magnetron cathode segments 102a-d. The magnetic coupling can expand the plasma across the surface of the segmented magnetron cathode 102 as described below. The power supply 1 28 generates a train of voltage pulses at the first output 126. The switch 110 directs the individual voltage pulses to the various magnetron cathode segments 102a-d in a predetermined sequence. One of the voltage pulses is applied to the first magnetron cathode segment 102a in order to ignite a plasma proximate to the first magnetron cathode segment 102a. In other embodiments, the voltage pulse can be applied to one of the other magnetron cathode segments 1 02b-d in order to ignite the plasma proximate to that magnetron cathode segment 102b-d.

Electrons 156 in the plasma are trapped by the magnetic field 154a. The trapped electrons 156 migrate toward the poles of the magnets 152a and 152b along magnetic field lines. Some of the electrons 156 that migrate towards the magnet 152b are reflected into the magnetic field 154b proximate to the second magnetron cathode segment 1 02b. The migrating reflected electrons 158 expand the plasma proximate to the second magnetron cathode segment 102b. As the plasma develops proximate to the other magnetron cathode segments 102b-d, the electrons in the plasma migrate along magnetic field lines of the various magnetic fields 154b-d. The electron migration that is caused by the magnetic coupling assists in creating additional plasma coupling across the surface of the segmented magnetron cathode 102. This can reduce the voltage level required to ignite a weakly-ionized plasma for a particular magnetron cathode segment 102a-d.

In one embodiment, an excited atom source 170, such as a metastable atom source is positioned to supply excited atoms 172 including metastable atoms proximate to the segmented magnetron cathode 102. The excited atoms 172 generated by the excited atom source 170 can increase the number of sputtered metal ions as well as the number of non-metal ions in the plasma and improve the uniformity of a coating generated by the plasma. For example, the energy of a metastable Argon atom (Ar*) is about 11 eV and the ionization energy for a copper atom (Cu) is about 7.7eV. In a reaction described by Ar* + Cu = Ar + Cu⁺ + e, Cu ions are created that can increase the density and improve the uniformity of the Cu ions that are distributed near the substrate. The excited atoms 172 can also improve the process of igniting the plasma and can increase the density of the plasma. Generating a plasma using excited atoms, such as metastable atoms, is described in co-pending U.S. Patent Application No. 10/249,844, entitled High-Density Plasma Source Using Excited Atoms, which is assigned to the present assignee.

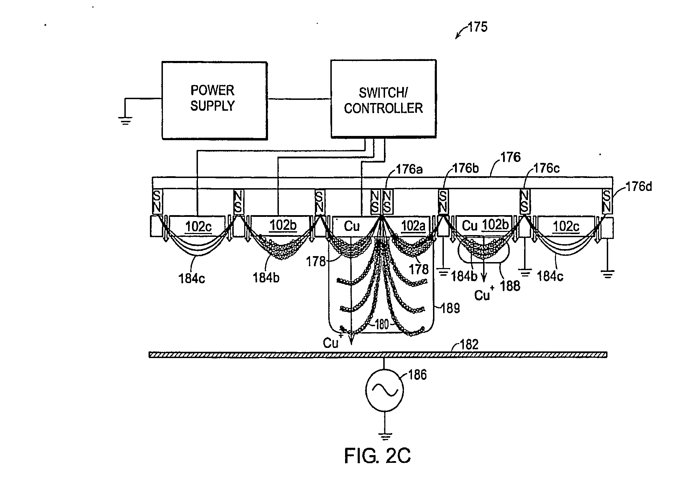

FIG. 2C illustrates a cross-sectional view of a plasma source 175 that includes the segmented magnetron cathode 102 of FIG. 1 with a magnet assembly 176 having an unbalanced magnet configuration that generates an unbalanced magnetic field. In this embodiment, the magnet 176a has a pole strength that is different than another cooperating magnet 176b. In this example, the pole strength of the magnet 176a is greater than the pole strength of the magnet 176b. In an unbalanced magnetron, the magnets 1 76a, 176b of the magnet assembly 176 create some closed magnetic field lines 178 that form an electron trap that confines the plasma proximate to the surface of the magnetron cathode section 102a. In addition, the magnets 176a, 176b of the magnet assembly 176 also create magnetic field lines 180 that project away from the magnetron cathode section 102a. The magnetic field lines 180 are referred to as open field lines and can extend away from the magnetron cathode section 102a and proximate to the substrate 182 to be coated. Other magnets 176b-d can generate balanced magnetic fields 184b-c or unbalanced magnetic fields (not shown) proximate to the other magnetron cathode segments 102b-c.

An unbalanced segmented magnetron according to the invention can increase the density of the plasma proximate to the substrate 182 to be coated. The increase in the density of the plasma is caused by electrons that are accelerated along the open magnetic field lines 180 towards the substrate 182. The electrons ionize atoms in the vicinity of the substrate 182. Additionally, some electrons that are accelerated along the open magnetic field lines 180 can charge the substrate 182 and create a bias on the substrate 182. In one embodiment, a power supply 186 negatively biases the substrate 182 which accelerates ions in the plasma towards the substrate 182.

The unbalanced segmented magnetron 1 75 can increase the ionization rate and the density of metal ions in an ionized physical vapor deposition (I-PVD) process. In one embodiment, the segmented magnetron cathode 102 includes copper target material. The copper target material is sputtered by ions in the plasma that bombard the segmented magnetron cathode 102. Copper atoms moving towards the substrate 182 can interact with the plasma that is located near the surface of the segmented magnetron cathode 102. Some of the copper atoms are ionized by electrons in the plasma. Maximizing the number of copper ions moving towards the substrate 182 is desirable in a I-PVD process. Other copper atoms that are not ionized pass through the plasma and are deposited on the substrate 182 and on the walls of the chamber (not shown).

An unbalanced magnetic field having open magnetic field lines 180 can increase the rate of ionization of metal ions and can increase the density of metal ions compared with a balanced magnetic field 184b having closed magnetic field lines. Referring to FIG. 2C, copper atoms sputtered from the magnetron cathode segment 1 02b pass through a volume 188 of plasma that is trapped by the balanced magnetic field 184b. Electrons in the plasma ionize some of the copper atoms passing through the plasma.

A volume 1 89 of plasma generated proximate to the first segmented magnetron cathode 102a is significantly larger than the volume 188 of plasma generated proximate to the second segmented magnetron cathode 102b. The open magnetic field lines 180 in the unbalanced magnetic field allow the plasma to expand towards the substrate 182. Copper atoms sputtered from the first magnetron cathode segment 102a pass through the volume 189 of plasma and are more likely to collide with an electron in the plasma and become ionized than copper atoms passing through the smaller volume 188 of plasma. Thus, the density of copper ions as well as the rate of ionization of copper atoms increases in an unbalanced magnetron compared to a balanced magnetron. An increased density of metal ions can improve an I-PVD process as previously discussed. An aluminum target can be used in the I-PVD process instead of a copper target. Also, many other metals, compounds, or alloys can be used in an I-PVD process according to the invention.

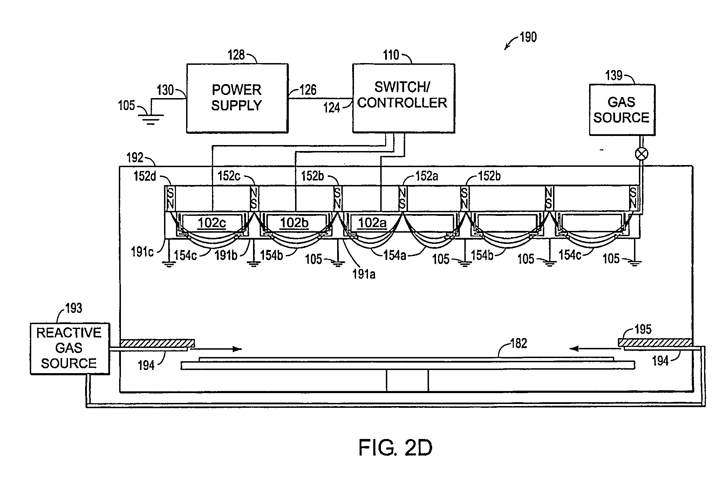

FIG. 2D illustrates a cross-sectional view of a plasma source 190 that includes a segmented magnetron cathode 102 that can be used for reactive sputtering. The segmented magnetron cathode 102 includes three magnetron cathode segments 1 02a-c. The magnetron cathode segments 102a-c can each include target material. The target material can be the same on each of the magnetron cathode segments 102a-c. In a compound sputtering process, there can be different target material included on each of the magnetron cathode segments 102a-c. The switch 110 includes a plurality of outputs that are coupled to the magnetron cathode segments 102a-c. An output 1 26 of the power supply 128 is coupled to an input 124 of the switch 110. The segmented magnetron cathode 102 also includes a magnet assembly 152. The magnet assembly 152 includes a plurality of magnets 152a-d that generate magnetic fields 154a-c proximate to the magnetron cathode segments 102a-c. The magnetic fields 154a-c can be balanced or unbalanced.

The plasma source 190 also includes a plurality of anode sections 191 a-c. The anode sections 191 a-c are shaped to deliver feed gas from the gas source 139 across the surface of each magnetron cathode segment 102a-c. The gas source 139 can include ground state gas atoms, excited gas atoms, or a combination of ground state atoms and excited atoms. In one embodiment, an excited atom source (not shown) is positioned between the gas source 139 and the chamber 192. The gas source 139 delivers ground state gas atoms to the excited atom source. The excited atom source raises the energy of the ground state atoms to create excited atoms and then the excited atoms are delivered to the chamber 192.

The shape of each of the anode sections 191 a-c can be chosen to increase a rate of ionization of the feed gas by modifying the pressure of the feed gas entering the chamber 192. In some embodiments (not shown), the anode sections 191 a-c include internal gas injectors that supply the feed gas directly into the gap between each specific anode section 191 a-c and the corresponding magnetron cathode segment 102a-c. The gas injectors can each supply different gases and/or excited atoms depending on the specific plasma process.

A reactive gas source 193 supplies reactive gas through a plurality of gas injectors 194. The reactive gas can include oxygen, nitrogen, nitrous oxide, carbon dioxide, chlorine, fluorine, or any other reactive gas or combination of gases. The reactive gas source 193 can supply any combination of ground state and/or excited gas atoms. Gas valves (not shown) or other gas controllers (not shown) can precisely meter the reactive gas into the chamber 192. In one embodiment, an excited atom source (not shown) is positioned between the reactive gas source 193 and the gas injectors 194. The reactive gas source 193 delivers ground state reactive gas atoms to the excited atom source. The excited atom source raises the energy of the ground state atoms to create excited atoms and then the excited atoms are supplied to the chamber 192 through the gas injectors 194.

The reactive gas is supplied near the substrate 182. A shield 1 95 can be used to reduce the quantity of reactive gas that can directly travel towards the segmented magnetron cathode 102. The shield does not, however, completely prevent the reactive gas from diffusing towards the segmented magnetron cathode 102 and eventually interacting with the segmented magnetron cathode 102. A segmented magnetron cathode 102 including target material can be damaged during the interaction with a reactive gas.

The operation of the plasma source 190 is similar to the operation of the plasma source 100 of FIG. 1. The gas source 1 39 provides feed gas between the anode sections 191 a-c and the magnetron cathode segments 102a-c including the target material. The gas pressure can be adjusted to optimize the ionization process by modifying the flow rate of the gas and modifying the shape and position of the anode sections 191 a-c relative to the corresponding magnetron cathode segments 102a-c. The power supply 128 provides voltage pulses to the switch 110. The switch 110 routes the voltage pulses to the various magnetron cathode segments 1 02a-c to ignite and maintain a high density plasma. The reactive gas source 193 supplies reactive gas in the vicinity of the substrate 182. Some of the reactive gas diffuses towards the segmented magnetron cathode 102. The reactive gas can interact with the target material and eventually damage the target material. The pressure of the gas flowing across the surface of the magnetron cathode segments 102a-c can be adjusted to reduce the amount of reactive gas that might interact with and eventually poison the target material.

Positively-charged ions in the high-density plasma are accelerated towards the negatively-charged segmented magnetron cathode 102. The highly accelerated ions sputter target material from the segmented magnetron cathode 102. The bombardment of the segmented magnetron cathode 102 with highly accelerated ions and the resulting intensive sputtering of the target material can also prevent the reactive gas from damaging the target material. During the sputtering process, a large fraction of the sputtered material is directed towards the substrate 182 and passes through the reactive gas. The reactive gas interacts with the sputtered material and changes the properties of the sputtered material, thereby creating a new material that sputter coats the substrate 182. In one embodiment, a reactive sputtering process and an I-PVD process can be performed together in a combined process. For example, in order to sputter TaN or TiN or other compounds to fill high-aspect-ratio structures on the substrate 182, a reactive sputtering process and an I-PVD process can be used.

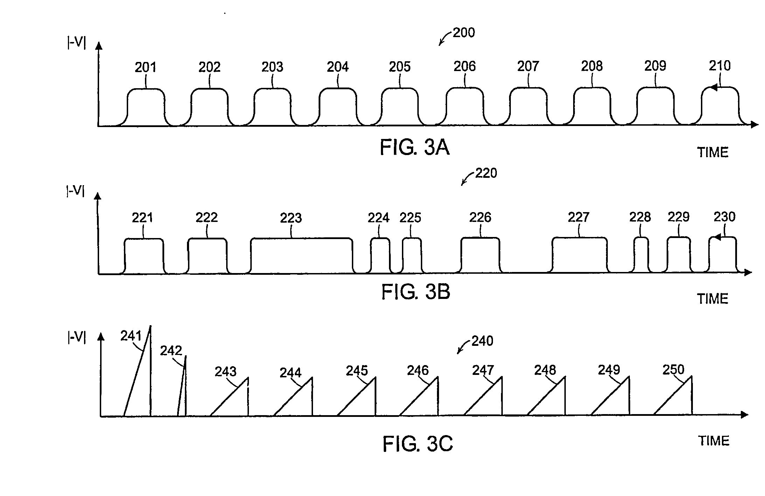

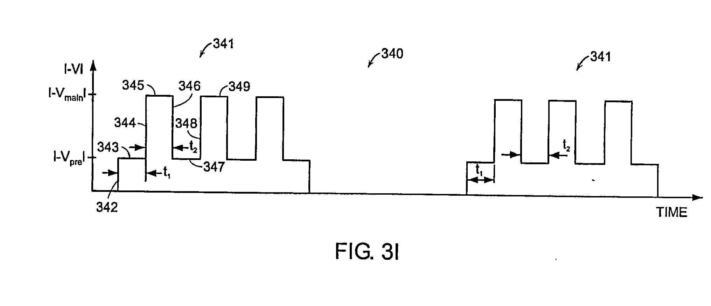

FIG. 3A is a graphical representation of an exemplary voltage pulse train 200 for energizing the plasma source 100 of FIG. 1 . The power supply 128 generates the individual square voltage pulses 201, 202, 203, 204, 205, 206, 207, 208, 209, 210 at the first output 126. The switch 110 receives the individual voltage pulses 201, 202, 203, 204, 205, 206, 207, 208, 209, 210 at the input 124 and routes the voltage pulses 201, 202, 203, 204, 205, 206, 207, 208, 209, 210 in a predetermined sequence to various outputs 108, 114, 118, 122 of the switch 110 which are coupled to the various respective magnetron cathode segments 102a-d. The sequence can be altered during the process to achieve certain process parameters, such as improved uniformity of the sputtered coating.

In one embodiment, the switch 110 routes each of the voltage pulses 201, 202, 203, 204, 205, 206, 207, 208, 209, 210 from the first output 126 of power supply 128 to each of the magnetron cathode segments 102a-d in the following manner. The first voltage pulse 201 is applied to the first magnetron cathode segment 102a, which ignites and sustains a plasma proximate to the first magnetron cathode segment 102a. The second voltage pulse 202 is applied to the second magnetron cathode segment 102b, which ignites and sustains a plasma proximate to the second magnetron cathode segment 1 02b. During these pulses, magnetron cathode segments deposit coatings on the substrate. The third voltage pulse 203 is applied to the third magnetron cathode segment 1 02c, which ignites a plasma proximate to the third magnetron cathode segment 102c.

The fourth voltage pulse 204 is applied to the fourth magnetron cathode segment 102d to ignite and sustain a plasma proximate to the fourth magnetron cathode segment 1 02d. The fifth voltage pulse 205 is applied to the fourth magnetron cathode segment 102d to increase coating thickness sputtered on the substrate proximate to the magnetron cathode segment 102d.

The sixth voltage pulse 206 is applied to the first magnetron cathode segment 102a to increase coating thickness sputtered on the substrate proximate to the magnetron cathode segment 102d. The seventh voltage pulse 207 is applied to the second magnetron cathode segment 102b to increase coating thickness sputtered on the substrate proximate to the magnetron cathode segment 102b.

The eighth voltage pulse 208 is applied to the third magnetron cathode segment 102c. The ninth 209 and the tenth voltage pulses 210 are applied to the fourth magnetron cathode segment 1 02d. The switch 110 controls the routing of the individual voltage pulses 201, 202, 203, 204, 205, 206, 207, 208, 209, and 210 in order to control the uniformity of the coating on the substrate 141 and the density of the plasma across the segmented magnetron cathode 102.

The preceding example illustrates the flexibility that can be achieved with the plasma source 100 including the segmented magnetron cathode 102 of FIG. 1. The switch 110 can be a programmable switch that routes one or more voltage pulses to the various magnetron cathode segments 102a-d in a predetermined manner in order to determine the precise distribution of the plasma across the magnetron cathode segments 102a-d, which controls the uniformity of the coating on the substrate 141. The switch 110 can also include a controller that modifies the sequence of the individual voltage pulses to the various magnetron cathode segments 1 02a-d in response to feedback from measurements taken during a plasma process.

FIG. 3B is a graphical representation of another exemplary voltage pulse train 220 for energizing the plasma source 100 of FIG. 1 that is chosen to generate a plasma having particular properties. The power supply 128 generates the individual voltage pulses 221, 222, 223, 224, 225, 226, 227, 228, 229, 2 30 at the first output 126. The switch 110 receives the individual voltage pulses 221 , 222, 223, 224, 225, 226, 227, 228, 229, 230 at the input 124 and routes the individual voltage pulses 221, 222, 223, 224, 225, 226, 227, 228, 229, 230 to various outputs 108, 114, 118, 122 of the switch 110 which are coupled to the various magnetron cathode segments 102a-d.

In one embodiment, the switch 110 routes each of the individual voltage pulses 221, 222, 223, 224, 225, 226, 227, 228, 229, 230 from the first output 126 of the power supply 128 to each of the magnetron cathode segments 102a-d in the following manner. The first voltage pulse 221 is applied to the fourth magnetron cathode segment 102d. The first voltage pulse 221 ignites and sustains a plasma proximate to the fourth magnetron cathode segment 102a. The second voltage pulse 222 is applied to the third magnetron cathode segment 1 02c to ignite and sustain a plasma proximate to the third magnetron cathode segment 102c. The third voltage pulse 223 is applied to the first magnetron cathode segment 1 02a to ignite and sustain a plasma proximate to the first magnetron cathode segment 1 02a. The plasma proximate to the first 1 02a and the third magnetron cathode segments 102c will tend to migrate towards the second magnetron cathode segment 1 02b because of the magnetic coupling described herein.

The fourth voltage pulse 224 is applied to the second magnetron cathode segment 102b to ignite and sustain a plasma proximate to the second magnetron cathode segment 102b. During this pulse, the second magnetron cathode segment 102 deposit coatings on the substrate. The fifth voltage pulse 225 is applied to the first magnetron cathode segment 702a to increase coating thickness on the substrate proximate to the magnetron cathode segment 102a. The sixth voltage pulse 226 is applied to the fourth magnetron cathode segment 102d to increase coating thickness on the substrate proximate to the magnetron cathode segment 102d. The seventh voltage pulse 227 is applied to the third magnetron cathode segment 1 02c to increase coating thickness on the substrate proximate to the magnetron cathode segment 102c. The eighth voltage pulse 228 is applied to the second magnetron cathode segment 102b to increase coating thickness on the substrate proximate to the magnetron cathode segment 1 02b. The ninth voltage pulse 229 is applied to the first magnetron cathode segment 102a. The tenth voltage pulse 230 is applied to the fourth magnetron cathode segment 102d.

The preceding example illustrates the flexibility of the plasma source 100 having the segmented magnetron cathode 102. Each of the individual voltage pulses 221, 222, 223, 224, 225, 226, 227, 228, 229, 230 generated by the power supply 128 can have a different shape, different pulse width, and a different repetition rate. The power supply 128 is programmable and can generate voltage pulses that each have different pulse parameters. Additionally, the switch 110 can route one or more of the voltage pulses 221, 222, 223, 224, 225, 226, 227, 228, 229, 230 to one or more of the magnetron cathode segments 102a-d to control the density of the plasma and the uniformity of the sputtered coating:

FIG. 3C is a graphical representation of another exemplary voltage pulse train 240 for energizing the plasma source 100 of FIG. 1 that is chosen to generate a plasma having particular properties. The power supply 128 generates the individual voltage pulses 241, 242, 243, 244, 245, 246, 247, 248, 249, 250 at the first output 126. The voltage pulses 241, 242, 243, 244, 245, 246, 247, 248, 249, 250 in this example are substantially saw tooth in shape. The first 241 and the second 242 voltage pulses have magnitudes and rise times that are different than the other voltage pulses in the voltage pulse train 240. These first two voltage pulses 241, 242 generate a plasma having the desired plasma density. The switch 110 receives the individual voltage pulses 241, 242, 243, 244, 245, 246, 247, 248, 249, 250 at the input 1 24 and routes the voltage pulses 241, 242, 243, 244, 245, 246, 247, 248, 249, 250 to particular outputs 108, 114, 118, 122 of the switch 110 that are coupled to particular magnetron cathode segments 102a-d.

In one embodiment, the switch 110 routes each of the voltage pulses 241 , 242, 243, 244, 245, 246, 247, 248, 249, 250 from the first output 12 6 power supply 128 to each of the magnetron cathode segments 102a-d in the following manner. The first voltage pulse 241 is applied to the first magnetron cathode segment 1 02a. The first voltage pulse 241 has a sufficient magnitude and rise time to ign ite a weakly-ionized plasma and to increase the density of the weakly-ionized plasma to create a strongly-ionized plasma proximate to the first magnetron cathode segment 102a. The second voltage pulse 242 is also applied to the first magnetron cathode segment 102a. In one embodiment, the rise time of the voltage pulses 241, 242, 243, 244, 245, 246, 247, 248, 249, 250 is less than about 400V per 1 µ sec. Controlling the rise time of the voltage pulses 241 , 242, 243, 244, 245, 246, 247, 248, 249, 250 can control the density of the plasma though various ionization processes as follows.

The second voltage pulse 242 has a magnitude and a rise time that is sufficient to ignite a weakly-ionized plasma and to drive the weakly-ionized plasma to a strongly-ionized state. The rise time of the second voltage pulse 242 is chosen to be sharp enough to ignite the weakly-ionized plasma and to shift the electron energy distribution of the weakly-ionized plasma to higher energy levels to generate ionizational instabilities that create many excited and ionized ato ms.

The magnitude of the second voltage pulse 242 is chosen to generate a strong enough electric field between the first magnetron cathode segment 102a and the anode section 104a to shift the electron energy distribution to higher energies. The higher electron energies create excitation, ionization, and recombination processes that transition the state of the weakly-ionized plasma to the strongly-ionized state.

The strong electric field generated by the second voltage pulse 242 between the first magnetron cathode segment 102a and the anode section 104a causes several different Ionization processes. The strong electric field causes some direct ionization of ground state atoms In the weakly-ionized plasma. There are many ground state atoms in the weakly-ionized plasma because of its relatively low-level of ionization. In addition, the strong electric field heats electrons initiating several other different types of ionization processes, such as electron impact, Penning ionization, and associative ionization. Plasma radiation can also assist in the formation and maintenance of the high current discharge. The direct and other ionization processes of the ground state atoms in the weakly-ionized plasma significantly increase the rate at which a strongly-ionized plasma is formed. Some of these ionization processes are further described in co-pending U.S. Patent Application No. 10/708,281, entitled Methods and Apparatus for Generating Strongly-ionized Plasmas with Ionizational instabilities which is assigned to the present assignee.

The third voltage pulse 243 is applied to the second magnetron cathode segment 102b and ignites a plasma proximate to the second magnetron cathode segment 102b. The fourth voltage pulse 244 is applied to the third magnetron cathode segment 102c and ignites a plasma proximate to the third magnetron cathode segment 102c. The fifth voltage pulse 245 is applied to the fourth magnetron cathode segment 102b and ignites a plasma proximate to the fourth magnetron cathode segment 102d. The sixth voltage pulse 246 is applied to the first magnetron cathode segment 102a and maintains the plasma proximate to the first magnetron cathode segment 102a at the desired plasma density and the desired plasma uniformity in order to obtain the desired coating uniformity on the substrate.

The seventh voltage pulse 247 is applied to the second magnetron cathode segment 102b. The eighth voltage pulse 248 is applied to the third magnetron cathode segment 102c. The ninth voltage pulse 249 is applied to the fourth magnetron cathode segment 102d. The tenth voltage pulse 250 is applied to the first magnetron cathode segment 102a. The third 243 through the tenth voltage pulse 250 maintain the plasma at the desired plasma density and the desired plasma uniformity. The magnitude, rise time, fall time, shape, and duration of the first 241 and the second voltage pulses 242 are chosen to generate a plasma having the desired density and uniformity to create a uniform coating on the substrate 141.

The saw-tooth shape of the voltage pulse train 240 does not sustain the strongly-ionized plasma because each of the voltage pulses 241, 242, 243, 244, 245, 246, 247, 248,249, 250 is abruptly terminated. Each of the voltage pulses 241, 242, 243, 244, 245, 246, 247, 248,249, 250 can have different rise times and/or different voltage levels. The preceding example illustrates the flexibility of the plasma source 100 having the power supply 128 and the switch 110. One or more of the voltage pulses 241, 242, 243, 244, 245, 246, 247, 248, 249, 250 generated by the power supply 128 can have a different magnitude and/or rise time. Additionally, the switch 110 can route one or more of the individual voltage pulses 241, 242, 243, 244, 245, 246, 247, 248, 249, 250 to one or more of the magnetron cathode segments 102a-d in a predetermined sequence.

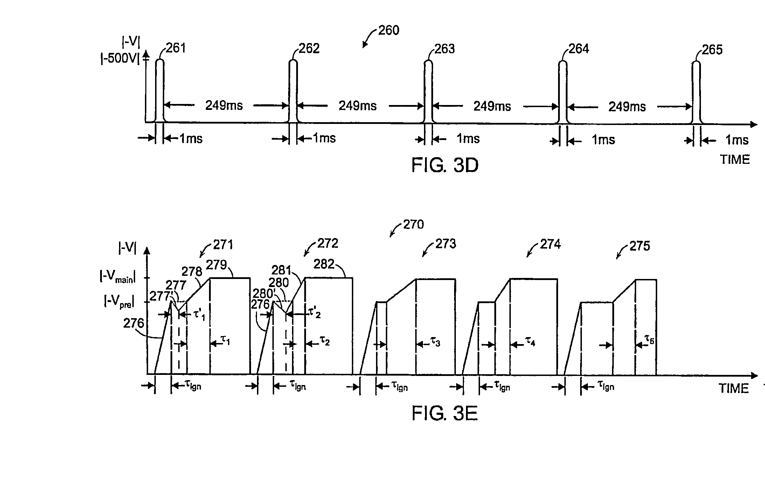

FIG. 3D is a graphical representation of another exemplary voltage pulse train 260 for energizing the plasma source 100 of FIG. 1 that is chosen to generate a plasma having particular properties. The power supply 128 generates the voltage pulses 261, 262, 263, 264, 265 in the voltage pulse train 260 at the first output 126. The voltage pulses 261, 262, 263, 264, 265 in this example have a magnitude of about 500V, a pulse width of about 1ms, and a repetition rate of about 5Hz. The switch 110 receives the voltage pulses 261, 262, 263, 264, 265 at the input 124 and routes the individual voltage pulses 261, 262, 263, 264, 265 to specific outputs 108, 114, 118, 122 of the switch 110 which are coupled to specific magnetron cathode segments 102a-d.

In one embodiment, the switch 110 routes each of the voltage pulses 261, 262, 263, 264, 265 from the power supply 128 to each of the magnetron cathode segments 1 02a-d in the following manner. The first voltage pulse 261 is applied to the first magnetron cathode segment 102a. The first voltage pulse 261 has a magnitude of 500V and a pulse width of 1 ms which is sufficient to ignite a plasma proximate to the first magnetron cathode segment 102a. The second voltage pulse 262 is applied to the second magnetron cathode segment 102a. The second voltage pulse 262 has a magnitude of 500V and a pulse width of 1 ms that is sufficient to ignite a plasma proximate to the second magnetron cathode segment 102 b.

The third voltage pulse 263 is applied to the third magnetron cathode segment 102c and ignites a plasma proximate to the third magnetron cathode segment 102c. The fourth voltage pulse 264 is applied to the fourth magnetron cathode segment 102d and ignites a plasma proximate to the fourth magnetron cathode segment 102d. The fifth voltage pulse 265 is applied to the first magnetron cathode segment 102a and maintains the plasma proximate to the first magnetron cathode segment 102a at the desired plasma density and uniformity. In this example, the voltage pulses 261, 262, 263, 264, 265 are identical.

The preceding example illustrates the flexibility of the plasma source 100 including the switch 110. The switching speed of the switch 110 in this example should be less than 249ms in order to route each of the voltage pulses 261 , 262, 263, 264, 265 to the various magnetron cathode segments 102a-d during the desired time period. This switching speed can be achieved using various mechanical or electronic switching technology.

FIG. 3E is a graphical representation of another exemplary voltage pulse train 270 for energizing the plasma source 100 of FIG. 1 that is chosen to generate a plasma having particular properties. The power supply 128 generates the voltage pulses 271, 272, 273, 274, 275 at the first output 1 26. Each individual voltage pulse 271, 272, 273, 274, 275 in this example has two voltage levels. In other embodiments, at least two of the individual voltage pulses 271, 272, 273, 274, 275 have different voltage levels.

The first voltage level Vₚᵣₑ is a pre-ionization voltage level that is used to generate a pre-ionization plasma. The pre-ionization plasma is a weakly-ionized plasma. The weakly-ionized plasma has a plasma density that is less than about 10 ¹²cm⁻³ . In one embodiment, the pre-ionization voltage level has a magnitude that is between about 300V and 2000V. The second voltage level Vₘₐᵢₙ, is the main voltage level that generates a plasma having the desired plasma density. In one embodiment, two voltage levels are used to generate a plasma having a relatively high plasma density. The plasma having the relatively high plasma density is referred to as a high-density plasma or a strongly-ionized plasma. Typically, high-density plasmas will generate films at a high deposition rate compared with weakly-ionized plasmas. The density of the strongly-ionized plasma is greater than about 10¹² cm⁻³.

The difference in magnitude between the second voltage level V ₘₐᵢₙ and the first voltage level Vₚᵣₑ is between about 1 V and 500V in some embodiments. The switch 110 receives the individual voltage pulses 271, 272, 273, 274, 275 at the input 124 and routes the voltage pulses 271, 272, 273, 274, 275 to particular outputs 108, 114, 118, 122 of the switch 110 which are coupled to particular magnetron cathode segments 102a-d.

In one embodiment, the switch 110 routes each of the voltage pulses 271, 272, 273, 274, 275 from the output 126 of the power supply 128 to each of the magnetron cathode segments 102a-d in the following manner. The first voltage pulse 271 is applied to the first magnetron cathode segment 1 02a. A first time period 276 corresponding to an ignition phase of the pre-ionization plasma has a rise time τ_{ign} and a magnitude Vₚᵣₑ that are sufficient to ignite a weakly-ionized plasma proximate to the first magnetron cathode segment 102a.

A second time period 277 having a value of between about 1 microsecond and 10seconds is sufficient to maintain the weakly-ionized plasma. The voltage level during the second time period 277 can be constant or can decrease for a time period 277' according to a fall time τ₁'. The value of the fall time τ₁' is in the range of between about 1 microsecond and 10seconds. A third time period 278 of the first voltage pulse 271 has a rise time τ₁ that is less than about 400V/usec and a magnitude Vₘₐᵢₙ that is sufficient to increase the density of the plasma proximate to the first magnetron cathode segment 102a. The rise time τ₁ of the third time period 278 of the first voltage pulse 271 can be varied to control the density of the plasma including the amount the sputtered metal ions. A fourth time period 279 of the first voltage pulse 271 corresponds to the main phase of the first voltage pulse 271. The fourth time period 279 maintains the plasma at the desired plasma density. The magnitude of the voltage Vₘₐᵢₙ during the fourth time period 279 is in the range of between about 350V and 2500 V depending upon the particular application.

The second voltage pulse 272 is applied to the second magnetron cathode segment 102b. The first time period 276 of the second voltage pulse 272 corresponds to the ignition phase of the second voltage pulse 272 and has a rise time τ_{ign} and a magnitude Vₚᵣₑ that is sufficient to ignite a plasma proximate to the second magnetron cathode segment 102b. A second time period 280 of the second voltage pulse 272 is sufficient to maintain a weakly-ionized plasma proximate to the second magnetron cathode segment 1026. The voltage level during the second time period 280 can be constant or can decrease for a time period 280' according to a fall time τ₂ '. A third time period 281 of the second voltage pulse 272 has a rise time τ₂ and a magnitude Vₘₐᵢₙ that is sufficient to increase the density of the plasma proximate to the second magnetron cathode segment 102b.

The rise time τ₂ of the third time period 281 of the second voltage pulse 272 is sharper than the rise time τ₁ of the third time period 278 of the first voltage pulse 271. This sharper rise time τ₂ generates a higher-density plasma proximate to the second magnetron cathode segment 102b than the plasma generated proximate to the first magnetron cathode segment 102a. The fourth time period 282 of the second voltage pulse 272 corresponds to the main phase of the second voltage pulse 272.

The rise times τ₁ - τ₅ of the voltage pulses 271-275 can be chosen so that the voltage pulses 21 7-275 provide sufficient energy to the electrons in the weakly-ionized plasma to excite atoms in the plasma, ionize ground state or excited atoms, and/or increase the electron density in order to generate a strongly-ionized plasma. The desired rise time depends on the mean free time between collisions of the electrons between atoms and molecules in the weakly-ionized plasma that is generated from the feed gas. Also, the magnetic field from the magnetron can strongly affect on the electron mean free time between the collisions. Therefore, the chosen rise time depends on several factors, such as the type of feed gas, the magnetic field, and the gas pressure.

In one embodiment, the rise time τ₂ of the third time period 281 of the second voltage pulse 272 is sufficient to cause a multi-step ionization process (instead of direct ionization process by electron impact). In a first step, the second voltage pulse 272 Initially raises the energy of the ground state atoms in the weakly-ionized plasma to a level where the atoms are excited. For example, argon atoms require an energy of about 11.55eV to become excited. In a second step, the magnitude and rise time in the third time period 281 of the second voltage pulse 272 are chosen to create a strong electric field that ionizes the exited atoms. Excited atoms ionize at a much high rate than neutral atoms. For example, argon excited atoms only require about 4eV of energy to ionize while neutral atoms require about 15.76eV of energy to ionize. Additional, the collisions between excited argon atoms and ground state sputtered atoms, such as copper atoms, can create additional ions and electron that will increase plasma density. The multi-step ionization process is described in co-pending U.S. Patent Application No. 10/249,844, entitled High-Density Plasma Source using Excited Atoms, which is assigned to the present assignee.

The multi-step ionization process can be described as follows:

Ar + e⁻ → Ar* + e⁻

Ar^{*} + e⁻ → Ar⁺ + 2e ⁻

where Ar represents a neutral argon atom In the initial plasma, e⁻ represents an ionizing electron generated in response to an electric field, and Ar* represents an excited argon atom in the initial plasma. The collision between the excited argon atom and the Ionizing electron results In the formation of an argon Ion (Ar⁺) and two electrons.

In one embodiment, ions in the developing plasma strike the second magnetron cathode segment 102b causing secondary electron emission. These secondary electrons interact with neutral or excited atoms In the developing plasma. The interaction of the secondary electrons with the neutral or excited atoms further increases the density of Ions in the developing plasma as feed gas is replenished. Thus, the excited atoms tend to more rapidly ionize near the surface of the second magnetron cathode segment 102b than the neutral argon atoms. As the density of the excited atoms In the plasma increases, the efficiency of the ionization process rapidly increases. The increased efficiency can result in an avalanche-like increase In the density of the plasma that creates a strongly-ionized plasma proximate to the second magnetron cathode segment 102b.

The magnetic field 136b (FIG. 2A) generated by the magnet assembly 134b can also increase the density of the plasma. The magnetic field 136b that is located proximate to the second magnetron cathode segment 102b is sufficient to generate a significant electron ExB Hall current which causes the electron density in the plasma to form a soliton or other non-linear waveform that increases the density of the plasma. In some embodiments, the strength of the magnetic field 136b required to cause the electron density in the plasma to form such a soliton or non-linear waveform is in the range of fifty to ten thousand gauss (0.05 to 1 Tesla).

An electron *ExB* Hall current is generated when the voltage pulse train 270 applied between the segmented magnetron cathode 102a,b,c, d and the anode sections 104a, b, c, d generates primary electrons and secondary electrons that move in a substantially circular motion proximate to the cathode segments 102a, b, c, d according to crossed electric and magnetic fields. The magnitude of the electron *ExB* Hall current is proportional to the magnitude of the discharge current In the plasma. In some embodiments, the electron *ExB* Hall current is approximately In the range of three to ten times the magnitude of the discharge current.

In one embodiment, the electrons density increases in an avalanche-like manner because of electron overheating instability. Electron overheating instabilities can occur when heat is exchanged between the electrons in the plasma, the feed gas, and the walls of the chamber. For example, electron overheating instabilities can be caused when electrons In a weakly-ionized plasma are heated by an external field and then lose energy in elastic collisions with atoms In the feed gas. The elastic collisions with the atoms in the feed gas raise the temperature and lower the density of the feed gas. The decrease in the density of the gas results in an increase in the electron temperature because the frequency of elastic collisions In the feed gas decreases. The increase in the electron temperature again enhances the heating of the gas. The electron heating effect develops in an avalanche-like manner and can drive the weakly-ionized plasma into a strongly-ionized state.

The third 273, fourth 274, and fifth voltage pulses 275 can include time periods having various shapes and durations depending on the desired properties of the plasma. The preceding example illustrates the flexibility of the plasma source 100 having the power supply 128 and the switch 110. The power supply 128 can generate voltage pulses having various shapes and rise-times depending on the desired properties of the plasma. The switch can route each of the individual voltage pulses 271, 272, 273, 274, 275 to the particular magnetron cathode segments 102a-d depending on the desired uniformity of the sputtered coating and the desired density of the plasma.

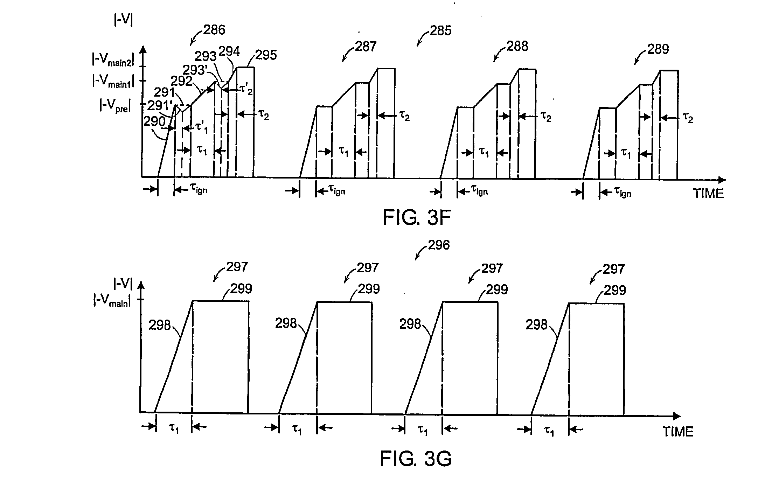

FIG. 3F is a graphical representation of another exemplary voltage pulse train 285 for energizing the plasma source 100 of FIG. 1 that is chosen to generate a plasma having particular properties. The power supply 128 generates the voltage pulses 286, 287, 288, 289 at the first output 126. In this example, the voltage pulses 286, 287, 288, 289 are identical and each voltage pulse has three voltage levels. In other embodiments, at least two of the voltage pulses 286, 287, 288, 289 have different voltage levels and/or include different rise times. The first voltage level V ₚᵣₑ has a magnitude that is between about 300V and 2000V. The difference in magnitude between the second voltage level V ₘₐᵢₙ₁ and the first voltage level V ₚᵣₑ is between about 1V and 500V. The difference in magnitude between the third voltage level V ₘₐᵢₙ₂ and the second voltage level V ₘₐᵢₙ₁ is between about 1 V and 500 V.

In one embodiment, the switch 110 routes each of the individual voltage pulses 286, 287, 288, 289 to the first 102a, the second 102b, the third 102c, and the fourth magnetron cathode segments 102d, respectively. Each of the voltage pulses 286, 287, 288, 289 includes six time periods. An ignition time period 290 of the first voltage pulse 286 has a rise time τ_{ign} A second time period 291 of the first voltage pulse 286 has a magnitude V that is between about 300 V and 2000 V and a duration pre that is between about 1 microsecond and 10seconds that is sufficient to ignite a weakly-ionized plasma proximate to the first magnetron cathode segment 102a. The voltage level during the second time period 291 can be constant or can decrease for a time period 291' according to a fall time τ₁ '.

A third time period 292 of the first voltage pulse 286 has a rise time τ₁ that is sufficient to increase the density of the plasma proximate to the first magnetron cathode segment 102a. The rise time τ₁ is less than about 300 V/ µ sec. The increase in the density of the plasma due to the sharpness of the rise time τ ₁ generates a high-density plasma or a strongly-ionized plasma from the weakly-ionized plasma proximate to the first magnetron cathode segment 102a.

A fourth time period 293 of the first voltage pulse 286 has a duration that is between about 1 microsecond and 10seconds and a magnitude Vₘₐᵢₙ₁ that is between about 300V and 2000 V, which is sufficient to maintain the high-density plasma. The voltage level during the fourth time period 293 can be constant or can decrease for a time period 293' according to a fall time τ ₂ '. A fifth time period 294 of the first voltage pulse 286 has a rise time τ₂ that is sufficient to increase the density of the high-density plasma proximate to the first magnetron cathode segment 102a. The rise time τ₂ is less than about 300 V/ µ sec. The increase in the density of the high-density plasma due to the sharpness of the rise time τ₂ generates a higher-density plasma or an almost fully-ionized plasma from the high-density plasma proximate to the first magnetron cathode segment 102a. A sixth time period 295 of the first voltage pulse 286 has a duration that is between about 1 microsecond and 10seconds and a magnitude Vₘₐᵢₙ₂ that is between about 400V and 3000V, which is sufficient to maintain the almost fully-ionized plasma.

The second 287, third 288, and fourth voltage pulses 289 include the same time periods as the first voltage pulse 286 and are each routed to particular magnetron cathode segments 102b-d depending on the desired properties of the plasma, such as the desired plasma density, deposition rate, and the uniformity of the sputtered coating.

FIG. 3G is a graphical representation of another exemplary voltage pulse train 296 for energizing the plasma source 100 of FIG. 1 that is chosen to generate a plasma having particular properties. In this example, the voltage pulses 297 are identical. In other embodiments, at least two of the voltage pulses 297 have different voltage levels and/or include different rise times. The power supply 128 generates the voltage pulses 297 at the first output 1 26. The voltage pulses 297 in this example each have only one voltage level. The voltage level Vₘₐᵢₙ has a magnitude that is between about 300V and 2000V.

In one embodiment, the switch 110 routes each of the voltage pulses 297 to the first 102a, the second 102b, the third 102c, and the fourth magnetron cathode segments 102d. Each of the voltage pulses 297 includes two time periods. A first time period 298 of each of the voltage pulses 297 has a rise time τ₁ that is sufficient to both ignite a weakly-ionized plasma and to increase the density of the weakly-ionized plasma. The rise time τ ₁ is less than about 400 V/ µ sec. A second time period 299 of each of the voltage pulses 297 has a duration that is between about 5microseconds and 10seconds and a magnitude V that is between about 300V and 2000V, main which is sufficient to maintain the plasma at the increased density level.

In this example, the voltage pulses 297 are applied to the magnetron cathode segment 102a without the express pre-ionization time period that was described in connection with previous examples. In this example, a plasma condition exists when the rise time τ₁ of the first phase 298 is such that a plasma develops having a plasma density that can absorb the power generated by the power supply 128. This plasma condition corresponds to a rapidly developing initial plasma that can absorb the power generated by the application of the voltage pulse 297 without the plasma contracting. Thus, the weakly-ionized plasma and the strongly-ionized plasma both develop in a single phase 298 of the voltage pulse 297. The strongly-ionized plasma is sustained in the phase 299 of the voltage pulse 297.

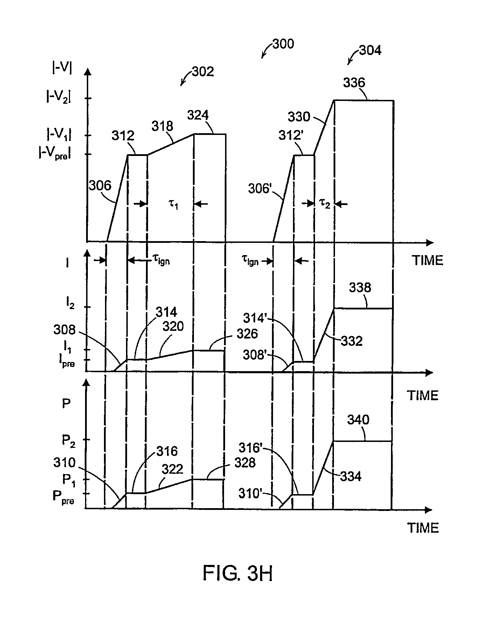

FIG. 3H is a graphical representation of yet another exemplary voltage pulse train 300 for energizing the plasma source 100 of FIG. 1 that is chosen to generate a plasma having particular properties. In this example, the voltage pulses 302, 304 each include four time periods. However, the magnitudes and rise times of the four time periods are different for each voltage pulse 302, 304.

The power supply 128 generates the voltage pulses 302, 304 at the output 126. The voltage pulses 302, 304 in this example each have two voltage levels. In one embodiment, the switch 110 routes both of the voltage pulses 302, 304 to the first magnetron cathode segment 102a. Each of the voltage pulses 302, 304 having the four time periods generates a plasma having different plasma properties, such as different plasma densities. In other embodiments, subsequent voltage pulses (not shown) are routed by the switch 110 to the other magnetron cathode segments 102b-d.

A first time period 306 of the first voltage pulse 302 has a rise time τ_{ign} that is sufficient to ignite a plasma proximate to the first magnetron cathode segment 102a. In one embodiment, the rise time τ_{ign} is less than about 400 V/ µ sec. The developing plasma has a discharge current 308 which increases as the magnitude of the voltage increases. Relatively few electrons exist before the plasma is ignited, therefore, the developing discharge current 308 lags behind the first time period 306 of the first voltage pulse 302 in time. The power 310 can be determined by taking the product of the voltage and the discharge current. The power 310 initially tracks the discharge current 308 in this example.

A second time period 312 of the first voltage pulse 302 has a duration and a magnitude Vₚᵣₑ that is sufficient to sustain a weakly-ionized plasma. In one embodiment, the magnitude of Vₚᵣₑ is between about 300V and 2000V. In one embodiment, the duration of the time period 312 is between about 1 microsecond and 10seconds. During the second time period 312, the discharge current 314 corresponding to the voltage Vₚᵣₑ plateaus at a value that corresponds to a relatively low density of the plasma. The power 316 during the second time period 312 is also at a relatively low level that corresponds to the relatively low density of the weakly-ionized plasma.

A third time period 318 of the first voltage pulse 302 has a rise time τ₁ that is sufficient to slightly increase the density of the weakly-ionized plasma. The rise time τ₁ is relatively long and therefore the voltage in the third time period 318 increases relatively slowly to a peak voltage V₁. The discharge current 320 also increases relatively slowly and reaches a relatively low peak current level I₁. The peak current I ₁ corresponds to a plasma density where there is insufficient electron energy gained in the third time period 318 to substantially increase the plasma density.

The power 322 reaches an intermediate peak power level P ₁ that corresponds to the peak discharge current I₁. If the duration of the third time period 318 of the first voltage 302 was extended to the duty cycle limit of the power supply 128, the peak discharge current I₁ would slowly increase, and the intermediate peak power level P ₁ would remain at a level that corresponds to a plasma having an intermediate plasma density.

A fourth time period 324 of the first voltage pulse 302 has a duration and a magnitude V ₁ that is sufficient to maintain the plasma having the intermediate plasma density. During the fourth time period 324, the discharge current 326 plateaus at a value that corresponds to the intermediate plasma density. The power 328 during the fourth time period 324 is also at a moderate level corresponding to a moderate density of the plasma.

A first time period 306' of the second voltage pulse 304 has a rise time τ_{ign} that is the same as the rise time τ_{ign} of the first time period 306 of the first voltage pulse 302. This rise time is sufficient to ignite a plasma proximate to the first magnetron cathode segment 102a. The developing plasma has a discharge current 308' which increases as the magnitude of the voltage increases and behaves similarly to the plasma ignited by the first time period 306 of the first voltage pulse 302. The developing discharge current 308' lags behind the first time period 306' of the second voltage pulse 304 in time. The power 310' initially tracks the discharge current 308'.

A second time period 312' of the second voltage pulse 304 has a duration and a magnitude Vₚᵣₑ that is the same as the duration and the magnitude Vₚᵣₑ of the second time period 312 of the first voltage pulse 302. The second time period 312' of the second voltage pulse 304 is sufficient to pre-ionize or precondition the plasma to maintain the plasma in a weakly-ionized condition. During the second time period 312', the discharge current 314' plateaus at a value that corresponds to the relatively low density of the plasma. The power 316' during the second time period 312' is also at a relatively low level that corresponds to the relatively low density of the weakly-ionized plasma.

A third time period 330 of the second voltage pulse 304 has a rise time τ₂ that is sufficient to rapidly increase the density of the plasma. The rise time τ₂ is relatively fast and, therefore, the voltage in the third phase 330 increases very quickly to a peak voltage having a magnitude V₂. In one embodiment, the rise time τ₂ is less than about 300 V/ µ sec. The density of the plasma and the uniformity of the sputtered coating can be modified by modifying at least one of the rise time τ₂, the peak voltage V₂ (amplitude), the fall time, the shape, and the duration of the second voltage pulse 304.

The sharp rise time τ₂ dramatically increases the number of electrons in the plasma that can absorb the power generated by the power supply 128 (FIG. 1). This increase in the number of electrons results in a discharge current 332 that increases relatively quickly and reaches a peak current level I₂ that corresponds to a high-density plasma condition. The peak current level I₂ corresponds to a point in which the plasma is strongly-ionized. The peak current level I₂, and therefore the plasma density, can be controlled by adjusting the rise time τ₂ of the third time period 330 of the second voltage pulse 304. Slower rise times generate lower density plasmas, whereas faster rise times generate higher density plasmas. A higher density plasma will generate coatings at a higher deposition rate.

The amplitude and rise time τ₂ during the third time period 330 of the second voltage pulse 304 can also support additional ionization processes. For example, the rise time τ₂ in the second voltage pulse 304 can be chosen to be sharp enough to shift the electron energy distribution of the weakly-ionized plasma to higher energy levels to generate ionizational instabilities that create many excited and ionized atoms. The higher electron energies create excitation, ionization, and recombination processes that transition the state of the weakly-ionized plasma to the strongly-ionized state.

The strong electric field generated by the second voltage pulse 304 can support several different ionization processes. The strong electric field causes some direct ionization of ground state atoms in the weakly-ionized plasma. There are many ground state atoms in the weakly-ionized plasma because of its relatively low-level of ionization. In addition, the strong electric field heats electrons initiating several other different types of ionization processes, such as electron impact, Penning ionization, and associative ionization. Plasma radiation can also assist in the formation and maintenance of the high current discharge. The direct and other ionization processes of the ground state atoms in the weakly-ionized plasma significantly increase the rate at which a strongly-ionized plasma is formed.

A fourth time period 336 of the second voltage pulse 304 has a duration that is between about 1 microsecond and 10seconds and a magnitude V₂ that is between about 300V and 2000V, which is sufficient to maintain a strongly-ionized plasma. During the fourth time period 336, the discharge current 338 plateaus at a level that corresponds to a relatively high plasma density. The power 340 during the fourth time period 336 is also at a relatively high-level that corresponds to the relatively high plasma density.

In some embodiments, voltage pulses having additional time periods with particular rise times can be used to control the density of the plasma. For example, in one embodiment the second voltage pulse 304 includes a fifth time period having an even sharper rise time. In this embodiment, the density of the strongly-ionized plasma is even further increased.

Thus, the density of the plasma as well as the uniformity of the resulting sputtered film generated by the plasma source 100 can be adjusted by adjusting at least one of a rise time, a fall time, an amplitude, a shape, and a duration of the voltage pulses. FIG. 3H illustrates that the third time period 318 of the first voltage pulse 302 having the relatively slow rise time τ₁ generates a relatively low peak current level I₁ that corresponds to a relatively low plasma density. In contrast, the third time period 330 of the second voltage pulse 304 has a rise time τ₂ that generates a relatively high peak current level I₂ that corresponds to a relatively high plasma density.

A sputtering system including the plasma source 100 (FIG. 2A) can deposit a highly uniform film with a high deposition rate. In addition, a sputtering system including a plasma source 100 having a segmented target corresponding to the segmented magnetron cathode 102 can be designed and operated so that the target material on the segmented target erodes in a uniform manner, resulting in full face erosion of the segmented target. The power supply 128 can also be effectively used to generate uniform high-density plasmas in magnetrons having one-piece planar magnetron cathodes.

The plasma source 100 of FIG. 2A is well suited for I-PVD systems. An I-PVD system including the plasma source 100 (FIG. 2A) can independently generate a more uniform coating, have a higher deposition rate, and have an increased ion flux compared with known I-PVD systems having one-piece planar cathodes.

FIG. 31 is a graphical representation of exemplary voltage pulse train 340 for energizing the plasma source 100 of FIG. 1 that is chosen to generate a plasma having particular properties. The voltage pulse train 340 includes individual voltage pulses 341 that are identical. Each of the individual voltage pulses 341 can include multiple peaks as shown in FIG. 31. The power supply 128 generates the voltage pulses 341 at the first output 126. The voltage pulses 341 in this example each have two voltage levels. The voltage level V has a magnitude that is between about 300V and pre 1,000V. The voltage level Vₘₐᵢₙ has a magnitude that is between about 300V and 2,000V.

Each of the voltage pulses 341 include multiple rise times and fall times. A first rise time 342 is sufficient to ignite a plasma from a feed gas. The first rise time can be less than 400V/usec. The magnitude 343 of the first voltage peak is sufficient to maintain a plasma in a weakly-ionized state. The time period t ₁ of the first voltage peak is between about 10microsecond and 1 second. A second rise time 344 and magnitude 345 of the second voltage peak is sufficient to increase the density of the weakly-ionized plasma to generate a strongly-ionized plasma from the weakly-ionized plasma. The second rise time 344 can be less than 400V/ µ sec. A fall time 346 of the second voltage peak is chosen to control the density of the strongly-ionized plasma in preparation for a third voltage peak. The fall time can be less than 400V/ µ sec. The second voltage peak is terminated after a time period t₂ The time period t₂ of the second voltage peak is between about 1 0microseconds and 1second.

After the termination of the second voltage peak, the voltage 345 drops to a voltage level 347 that corresponds to the voltage 343 of the first voltage peak. The voltage level 347 is chosen to maintain a sufficient density of the plasma in preparation for the third voltage peak. The rise time 348 and the magnitude 349 of the third voltage peak is sufficient to increase the density of the plasma to create a strongly-ionized plasma. Additional voltage peaks can also be used to condition the plasma depending on the specific plasma process. The voltage peaks can have various rise times, fall times, magnitudes, and durations depending on the desired properties of the plasma. The voltage pulses 341 of FIG. 31 can decrease the occurrence of arcing in the chamber by supplying very high power to the plasma in small increments that correspond to the voltage peaks. The incremental power is small enough to prevent an electrical breakdown condition from occurring in the chamber, but large enough to develop a strongly-ionized or high-density plasma that is suitable for high deposition rate sputtering. Additionally, the incremental power can prevent a sputtering target from overheating by holding the average temperature of the sputtering target relatively low.

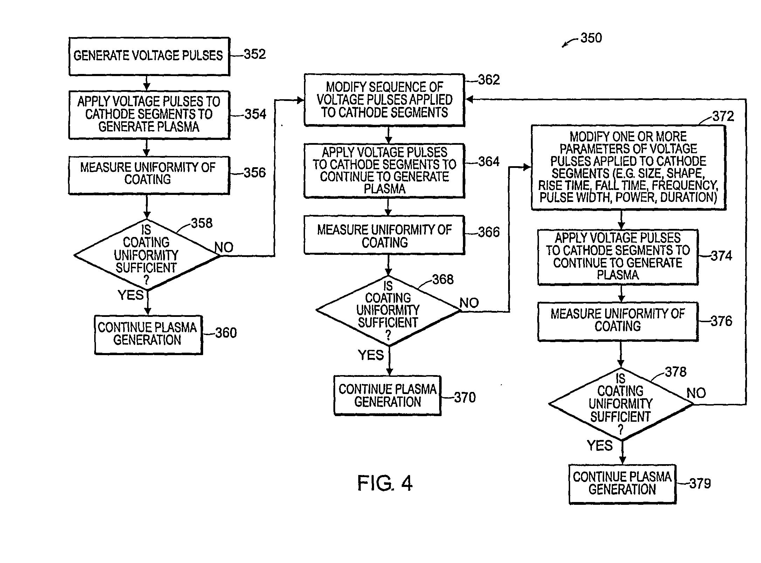

An operation of the plasma source 100 of FIG. 2A is described with reference to FIG. 4. This operation relates to generating a plasma and controlling the uniformity of the sputtered coating. FIG. 4 is a flowchart 350 of a method for generating a plasma according to one embodiment of the invention. The uniformity of the sputtered coating can be controlled by varying one or more parameters in the plasma source 100. Many parameters can be varied. For example, parameters related to the power supply 128, parameters related to the switch 110, parameters related to the gas source 139, and/or parameters related to the magnet assemblies 134a-d can be varied.

In step 352, the power supply 128 generates a pulse train at the output 126 comprising voltage pulses. In step 354, the switch 110 routes the voltage pulses to individual magnetron cathode segments 102a-d of the segmented magnetron cathode 102. The plasma sputters material from the individual magnetron cathode segments 102a-d. The material is deposited on a substrate to create a sputtered film or coating. The uniformity of the coating is measured in step 356. In step 358, the uniformity of the coating is evaluated. If the coating uniformity is found to be sufficient, the generation of the plasma continues in step 360.

If the coating uniformity is found to be insufficient, the sequence of the voltage pulses applied to the magnetron cathode segments 102a-d is modified in step 362. The sequence of the voltage pulses can be modified such that one or more voltage pulses are applied to each of the magnetron cathode segments 102a-d in any order that optimizes the uniformity of the sputtered coating.

Once the sequence of the voltage pulses is modified in step 362, the voltage pulses are routed to the various magnetron cathode segments 102a-d in step 364. The uniformity of the coating is again measured in step 366. In step 368, the uniformity of the coating is again evaluated. If the coating uniformity is found to be sufficient, the generation of the plasma continues in step 370.

If the coating uniformity is found to be insufficient in step 368, one or more parameters of the voltage pulses are modified in step 372. For example, the pulse width, the pulse shape, the rise time, the fall time, the magnitude, the frequency, and/or any other parameters that define the voltage pulses can be modified by the power supply 128. In step 374, the switch 110 routes the voltage pulses to the magnetron cathode segments 102a-d. The uniformity of the coating is again measured in step 376. In step 378, the uniformity of the coating is again evaluated. If the coating uniformity is found to be sufficient, the generation of the plasma continues in step 379.

If the coating uniformity is found to be insufficient in step 378, the sequence of the voltage pulses applied to the magnetron cathode segments 102a-d is again modified in step 362 and the process continues until the coating uniformity is sufficient for the specific plasma process.

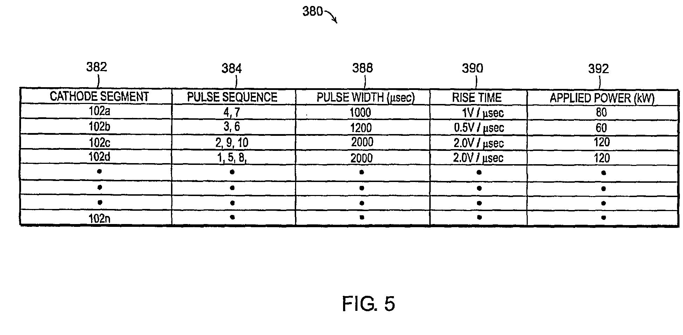

FIG. 5 is a table 380 of exemplary voltage pulse parameters that can be associated with particular magnetron cathode segments 102a-d (FIG. 1). The table 380 illustrates the many different voltage pulses parameters that can be applied to particular magnetron cathode segments 102a-d in order to achieve certain plasma densities and plasma uniformity.

The first column 382 of table 380 illustrates the specific magnetron cathode segment 102a-n to which a voltage pulse is applied. The second column 384 illustrates an exemplary pulse sequence that can be applied to the magnetron cathode segments 102a-d. In this exemplary pulse sequence: (1) the first pulse is applied to the fourth magnetron cathode segment 102d; (2) the second pulse is applied to the third magnetron cathode segment 102c; (3) the third pulse is applied to the second magnetron cathode segment 1 02b; (4) the fourth pulse is applied to the first magnetron cathode segment 102a; (5) the fifth pulse is applied to the fourth magnetron cathode segment 102d; (6) the sixth pulse is applied to the second magnetron cathode segment 102b; (7) the seventh pulse is applied to the first magnetron cathode segment 1 02a; (8) the eighth pulse is applied to the fourth magnetron cathode segment 102d; and (9) the ninth and tenth pulses are applied to third magnetron cathode segment 102c. In some embodiments, the pulses (first pulse through tenth pulse) are pulse trains each including at least two pulses. The specific pulse sequence can affect the density of the plasma and the uniformity of a resulting sputtered film across a workpiece.

The third column 388 illustrates exemplary voltage pulse widths in microseconds that are applied to each magnetron cathode segment 102a-d. In this example, a voltage pulse having a pulse width of 1,000 µ sec is applied to the first magnetron cathode segment 102a. A voltage pulse having a pulse width of 1,200 µ sec is applied to the second magnetron cathode segment 102b. Voltage pulses having pulse widths of 2,000 µ sec are applied to each of the third 102c and the fourth magnetron cathode segments 102d. The pulse width or pulse duration of each voltage pulse can affect the plasma density and properties of a resulting sputtered film.

The fourth column 390 illustrates exemplary rise times of the voltage pulses applied to the various magnetron cathode segments 102a-d. The rise times in the fifth column 390 correspond to the rise times τ₁, τ₂ of the third time periods 278, 281 of the voltage pulses 271, 272 illustrated in FIG. 3E. The fifth column 390 illustrates that voltage pulses having different rise times can be applied to different magnetron cathode segments 102a-d. The different rise times can generate plasmas having different plasma densities that are proximate to the various magnetron cathode segments 102a-d. As described herein, the rise times of the voltage pulses can strongly influence the rate of ionization and the density of the plasma.

In this example, a voltage pulse having a rise time of 1 V/ µ sec is applied to the first magnetron cathode segment 102a. A voltage pulse having a rise time of 0.5V/ µ sec is applied to the second magnetron cathode segment 102b. A voltage pulse having a rise time of 2V/ µ sec is applied to the third magnetron cathode segment 102c. A voltage pulse having a rise time of 2V/ µ sec is applied to the fourth magnetron cathode segment 102d. The voltage pulses applied to the magnetron cathode segments 102a-d can have faster rise times depending upon the design of the plasma source and the desired plasma conditions. A voltage pulse 271 (FIG. 3E) can include different time periods 277, 279 having different voltage levels and different durations that sustain plasmas having different plasma densities.

The fifth column 392 indicates the amount of power generated by the voltage pulses that are applied to each magnetron cathode segment 102a-d. In this example, the power generated by applying the voltage pulse to the first magnetron cathode segment 102a is 80kW. The power generated by applying the voltage pulse to the second magnetron cathode segment 1 02b is 60kW. The power generated by applying the voltage pulse to the third 1 02c and the fourth magnetron cathode segments 102d is 120kW. The power applied to each of the magnetron cathode segments 102a-d can affect the density of the plasma as well as the uniformity of a sputtered film across the substrate.

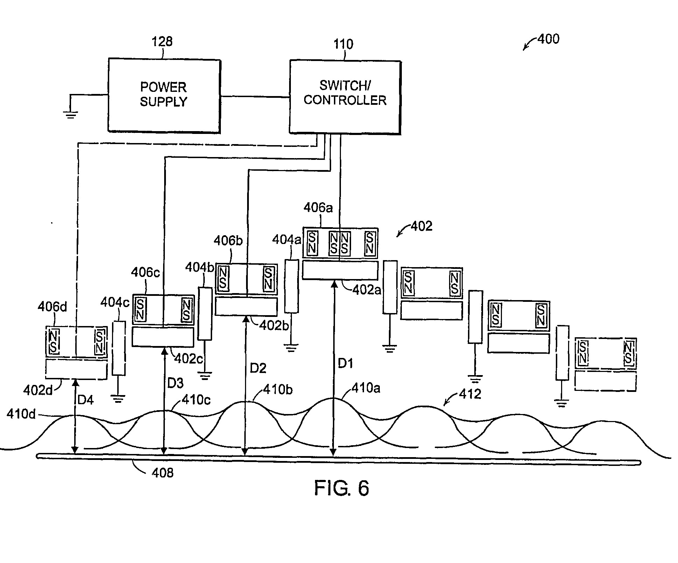

FIG. 6 illustrates a cross-sectional view of a plasma source 400 including a segmented magnetron cathode 402 according to one embodiment of the invention. The plasma source 400 includes the power supply 128 and the switch 110. The segmented magnetron cathode 402 includes a plurality of magnetron cathode segments 402a-d. The plurality of magnetron cathode segments 402a-d are typically electrically isolated from each other. Anodes 404a-c are positioned adjacent to the respective magnetron cathode segments 402a-d.

The plasma source 400 also includes magnet assemblies 406a-d that are positioned adjacent to the respective magnetron cathode segments 402a-d. The first magnet assembly 406a creates a magnetic field (not shown) proximate to the first magnetron cathode segment 402a. The magnetic field traps electrons in the plasma proximate to the first magnetron cathode segment 402a. Additional magnetic fields trap electrons in the plasma proximate to the other respective magnetron cathode segments 402b-d.

The magnet assemblies 406a-d can create magnetic fields having different geometrical shapes and different magnetic field strengths. Creating magnetic fields having different magnetic fields strengths can improve the uniformity of a sputtered film on a substrate 408. For example, the first magnet assembly 406a can includes strong magnets that create a stronger magnetic field than magnets that are included in the fourth magnet assembly 406d. A stronger magnetic field may be required proximate to the first magnetron cathode segment 402a, since the first magnet assembly 406a is further away from the substrate 408 than the fourth magnet assembly 406d.

The substrate 408 or workpiece is positioned proximate to the segmented magnetron cathode 402. The plasma source 400 can be used to sputter coat the substrate 408. In this embodiment, each of the magnetron cathode segments 402a-d includes target material. The power supply 128 and the switch 110 control the voltage pulses applied to each of the magnetron cathode segments 402a-d including the target material. The target material from each of the magnetron cathode segments 402a-d sputter coats the substrate 408 to generate coatings 410a-d that correspond to each of the magnetron cathode segments 402a-d.

The plasma source 400 illustrates that the magnetron cathode segments 402a-d in the segmented magnetron cathode 402 do not have to be in the same horizontal planes with respect to the substrate 408. In the example shown in FIG. 6, each of the magnetron cathode segments 402a-d is in a unique horizontal plane with respect to a plane that is parallel to the substrate 408. Each of the magnetron cathode segments 402a-d is also in a unique vertical plane with respect to a plane that is perpendicular to the substrate 408. For example, the distance D1 from the first magnetron cathode segment 402a to the substrate 408 is greater than the distance D2 from the second magnetron cathode segment 402b to the substrate 408.

In one embodiment, the distances D1-D4 between the respective magnetron cathode segments 402a-d and the substrate 408 can be varied to increase the uniformity of the sputtered coating or to optimize the plasma process. In addition to varying the distances D1-D4 in order to optimize the plasma process, the parameters of the power supply 128 and the switch 110 can be adjusted to affect the uniformity of the coatings 41 0a-d across the substrate 408. The coating uniformity 412 can be varied to create a predefined thickness profile across the substrate 408.

In one embodiment, the plasma source 400 is used to etch the substrate 408. In this embodiment, the plasma generated by segmented magnetron cathode 402 can have different densities at different locations across the surface of the substrate 408. Therefore, the plasma source 400 can be used to etch a substrate with a particular etch profile.

The operation of the plasma source 400 is similar to the operation of the plasma source 100 of FIG. 1. The switch 110 routes the voltage pulses from the power supply 128 to the various magnetron cathode segments 402a-d of the segmented magnetron cathode 402. The magnitude, shape, rise time, fall time, pulse width, and frequency of the voltage pulses, as well as the sequencing of the various voltage pulses are adjustable by the user to meet the requirements of a particular plasma process.

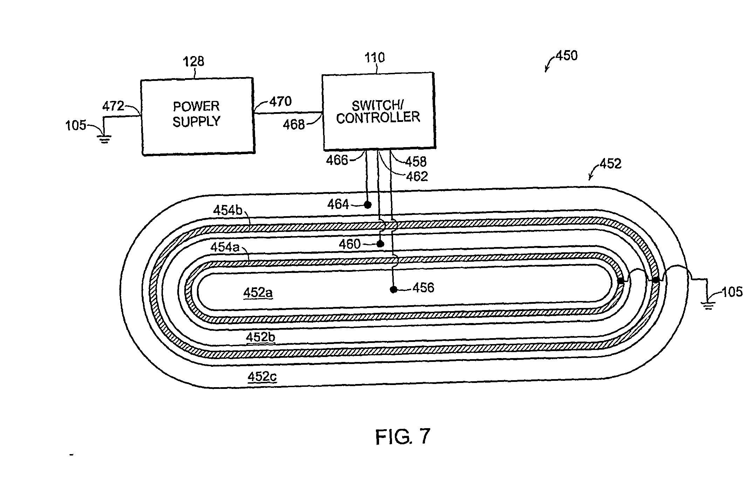

FIG. 7 illustrates a diagram of a plasma source 450 including a segmented cathode 452 having an oval shape according to one embodiment of the invention. The segmented cathode 452 is formed in the shape of an oval to facilitate processing large workpieces, such as architectural pieces or flat screen displays. In other embodiments, the segmented cathode 452 is formed into other shapes that generate desired plasma profiles across a particular workpiece. In the embodiment shown in FIG. 7, the plasma source 450 is not a segmented magnetron, and therefore, the segmented cathode 452 does not include magnets. However, in other embodiments, the plasma source 450 is a segmented magnetron and the segmented cathode 452 does include magnets.

The segmented cathode 452 includes a plurality of cathode segments 452a, 452b, and 452c. The plurality of cathode segments 452a-c are typically electrically isolated from each other. Some embodiments include additional cathode segments that meet the requirements of a specific plasma process. In one embodiment, the segmented cathode 452 includes target material that is used for sputtering. The target material can be integrated into or fixed onto each cathode segment 452a-c.

The plasma source 450 also includes a plurality of anodes 454a, 454b. The anodes 454a, 454b are positioned between the cathode segments 452a, 452b, 452c. Additional anodes can be positioned adjacent to additional cathode segments. In one embodiment, the anodes 454a, 454b are coupled to ground 105. In other embodiments (not shown), the anodes 454a, 454b are coupled to a positive terminal of a power supply.

An input 456 of the first cathode segment 452a is coupled to a first output 458 of the switch 110. An input 460 of the second cathode segment 452b is coupled to a second output 462 of the switch 110. An input 464 of the third cathode segment 452c is coupled to a third output 466 of the switch 110.

An input 468 of the switch 110 is coupled to a first output 470 of the power supply 128. A second output 472 of the power supply 128 is coupled to ground 105. In other embodiments (not shown), the second output 472 of the power supply 128 is coupled to the anodes 454a, 454b. The power supply 128 can be a pulsed power supply, a switched DC power supply, an alternating current (AC) power supply, or a radio-frequency (RF) power supply. The power supply 128 generates a pulse train of voltage pulses that are routed by the switch 110 to the cathode segments 452a-c.

The power supply 128 can vary the magnitude, the pulse width, the rise time, the fall time, the frequency, and the pulse shape of the voltage pulses depending on the desired parameters of the plasma and/or the desired uniformity of a sputtered coating. The switch 110 can include a controller or a processor and can route one or more of the voltage pulses to each of the cathode segments 452a-c in a predetermined sequence depending on the shape and size of the segmented cathode 452 and the desired uniformity of the coating, and the density and volume of the plasma. An optional external controller or processor (not shown) can be coupled to the switch 110 to control the routing of the voltage pulses in the pulse train.

The operation of the plasma source 450 is similar to the operation of the plasma source 100 of FIG. 1. The switch 110 routes the voltage pulses from the power supply 128 to the particular cathode segments 452a-c of the segmented cathode 452. The size and shape of the segmented cathode 452 can be adjusted depending on the size and shape of the workpiece to be processed. The shape, pulse width, rise time, fall time, and frequency of the voltage pulses, as well as the sequencing of the various voltage pulses can be varied depending on the specific plasma process.

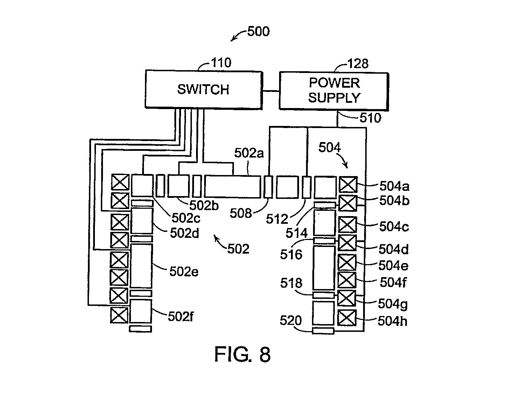

FIG. 8 illustrates a diagram of a plasma source 500 including a segmented magnetron cathode 502 in the shape of a hollow cathode magnetron (HCM) according to one embodiment of the invention. The plasma source 500 includes at least one magnet assembly 504a that is positioned adjacent to a third magnetron cathode segment 502c. Additional magnet assemblies 504b-h are positioned adjacent to fourth 502d, fifth 502e, and sixth magnetron cathode segments 502f. The magnet assemblies 504a-h create magnetic fields proximate to the magnetron cathode segment 502a-f. The magnetic fields trap electrons in the plasma proximate to the magnetron cathode segments 502a-f.

In some embodiments, the magnet assemblies 504a-h are electro-magnetic coils. The shape and strength of the magnetic fields generated by the coils vary depending on the current applied to the coil. The magnetic fields can be used to direct and focus the plasma in the HCM. In some embodiments, one or more of the magnet assemblies 504a-h generate unbalanced magnetic fields. The unbalanced magnetic fields can improve the plasma process as previously described.

A first anode 508 is positioned proximate to the first 502a and the second magnetron cathode segments 502b. The first anode 508 is coupled to a first output 510 of the power supply 128. A second anode 512 is positioned proximate to the third magnetron cathode segment 502c and is coupled to the first output 510 of the power supply 128. A third anode 514 is positioned proximate to the fourth magnetron cathode segment 502d and is coupled to the first output 510 of the power supply 128. A fourth anode 516 is positioned proximate to the fifth magnetron cathode segment 502e and is coupled to the first output 510 of the power supply 1 28. A fifth anode 518 is positioned proximate to the sixth magnetron cathode segment 502f and is coupled to the first output 510 of the power supply 128. A sixth anode 520 is also positioned proximate to the sixth magnetron cathode segment 502f and is coupled to the first output 510 of the power supply 128. In other embodiments, the number of anode and magnetron cathode segments is different.

Each of the plurality of magnetron cathode segments 502a-f is coupled to an output of the switch 110. The plurality of magnetron cathode segments 502a-f are typically electrically isolated from each other. However, there are embodiments in which two or more magnetron cathode segments 502a-f can be electrically coupled together.

A substrate or workpiece (not shown) is positioned adjacent to the segmented magnetron cathode 502. The plasma source 500 can be used to coat the substrate. In this embodiment, each of the magnetron cathode segments 502a-f includes target material. The power supply 128 and the switch 110 control the voltage pulses applied to each of the magnetron cathode segments 502a-f including the target material. The target material from each of the magnetron cathode segments 502a-f sputter coats the substrate. Parameters of the power supply 128, the switch 110, and the magnet assembly 504, can be adjusted to increase the uniformity of the sputtered coating and to adjust the density of the plasma to improve the plasma process.

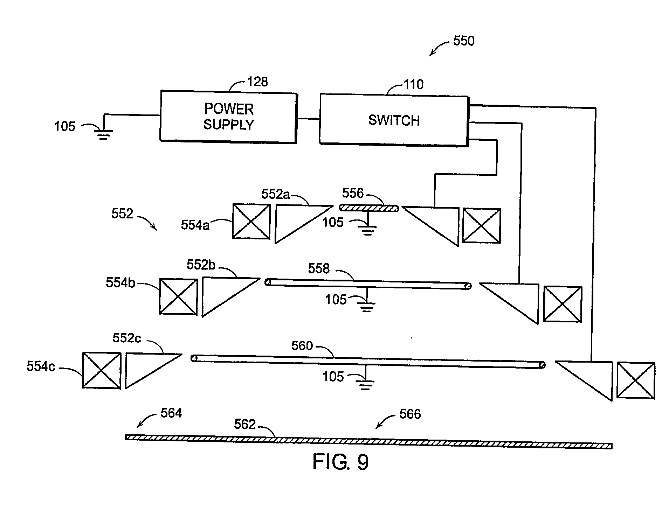

FIG. 9 illustrates a diagram of a plasma source 550 including a segmented magnetron cathode 552 in the shape of a conical cathode magnetron according to one embodiment of the invention. The plasma source 550 includes a first magnet assembly 554a that is positioned adjacent to a first magnetron cathode segment 552a. A second magnet assembly 554b is positioned adjacent to a second magnetron cathode segment 552b. A third magnet assembly 554c is positioned adjacent to a third magnetron cathode segment 552c. Each of the magnet assemblies 554a-c can generate magnetic fields having different strengths and different geometries that are chosen to optimize the specific plasma process.

The magnet assemblies 554a-c can include coils or can include permanent magnets. The first magnet assembly 554a creates a magnetic field (not shown) proximate to the first magnetron cathode segment 552a. The first magnetic field traps electrons in the plasma proximate to the first magnetron cathode segment 552a. The second magnetic field (not shown) traps electrons in the plasma proximate to the second magnetron cathode segment 552b. The third magnetic field (not shown) traps electrons in the plasma proximate to the third magnetron cathode segment 552c. In some embodiments, one or more of the magnet assemblies 554a-c generate unbalanced magnetic fields. The unbalanced magnetic fields can be used to optimize the particular plasma process.

A first anode 556 is positioned proximate to the first magnetron cathode segment 552a. A second anode 558 is positioned proximate to the second magnetron cathode segment 552b. A third anode 560 is positioned proximate to the third magnetron cathode segment 552c. In one embodiment, the first 556, the second 558, and the third anodes 560 are formed in the shape of a ring. The first 556, the second 558, and the third anodes 560 are coupled to ground 105.

A substrate 562 is positioned adjacent to the segmented magnetron cathode 552. The plasma source 550 can be used to coat the substrate 562. In this embodiment, each of the magnetron cathode segments 552a-c includes target material. The power supply 128 and the switch 110 control the voltage pulses applied to each of the magnetron cathode segments 552a-c including the target material. The target material from each of the magnetron cathode segments 552a-c sputter coats the substrate. Parameters of the power supply 128, the switch 110, and the magnet assemblies 554a-c, can be adjusted to increase the uniformity of the plasma to improve the plasma process.

For example, if the sputtered film on the substrate 562 is non-uniform such that the film is thicker on the edge 564 of the substrate 562 than in the center 566 of the substrate 562, the switch 110 can route a greater number of voltage pulses to the first magnetron cathode segment 552a than to the third magnetron cathode segment 552c in order to increase the thickness of the sputtered film proximate to the center 566 of the substrate 562. Alternatively, the switch 110 can route voltage pulses having longer pulse widths to the first magnetron cathode segment 552a and voltage pulses having shorter pulse widths to the third magnetron cathode segment 552c. Numerous other combination of applying different numbers of voltage pulses and/or voltage pulses having different pulse widths can be used.

Conversely, if the sputtered coating on the substrate 562 is non-uniform such that the film is thicker in the center 566 of the substrate 562 than on the edge 564 of the substrate 562, the switch 110 can route a greater number of voltage pulses to the third magnetron cathode segment 552c in order to increase the thickness of the sputtered film on the edge 564 of the substrate 562. Alternatively, the switch 110 can route voltage pulses having longer pulse widths to the third magnetron cathode segment 552c and voltage pulses having shorter pulse widths to the first magnetron cathode segment 552a.

In addition, the power supply 128 can change the plasma density proximate to the various magnetron cathode segments 552a-c by varying the rise times of the voltage pulses applied to the various magnetron cathode segments 552a-c. For example, voltage pulses having very fast rise times can generate higher density plasmas that increase the sputtering rate of the target material.

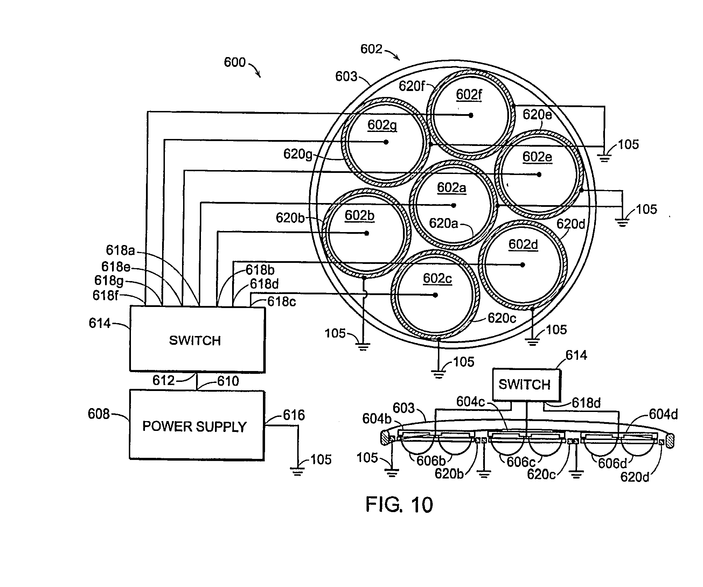

FIG. 10 illustrates a diagram of a plasma source 600 including a segmented magnetron cathode 602 in the shape of a plurality of small circular magnetron cathode segments 602a-g according to one embodiment of the invention. The plurality of small circular magnetron cathode segments 602a-g are surrounded by a housing 603.

Each of the small circular magnetron cathode segments 602a-g includes a magnet assembly 604a-g (only 604b-d are shown for clarity) that generates a magnetic field 606a-g (only 606b-d are shown for clarity) proximate to each respective small circular magnetron cathode segment 602a-g. The magnet assemblies 604a-g can include coils or can include permanent magnets. Each magnetic field 606a-g traps electrons in the plasma proximate to each respective small circular magnetron cathode segment 602a-g. Alternative magnet assemblies can be used to generate magnetic fields across one or more of the small circular magnetron cathode segments 602a-g. Each of the magnet assemblies 604a-g can generate magnetic fields having different strengths and geometries. One or more of the magnet assemblies 604a-g can also generate an unbalanced magnetic field.

The plasma source 600 also includes a power supply 608. A first output 610 of the power supply 608 is coupled to an input 612 of a switch 614. A second output 61 6 of the power supply 608 is coupled to ground 105. The switch 614 includes multiple outputs 618a-g that are each coupled to a respective one of the small circular magnetron cathode segments 602a-g. In one embodiment, the switch 614 includes an integrated controller or processor. The plurality of magnetron cathode segments 602a-g are typically electrically isolated from each other, but two or more can be electrically coupled together in some embodiments.

Each of the small circular magnetron cathode segments 602a-g is surrounded by a respective anode 620a-g. In one embodiment, the anodes 620a-g are formed in the shape of a ring. The anodes 620a-g are coupled to ground 105. In one embodiment, the anodes 620a-g are coupled to the second output 616 of the power supply 608.

A substrate (not shown) is positioned adjacent to the segmented magnetron cathode 602. The plasma source 600 can be used to coat the substrate. In this embodiment, each of the small circular magnetron cathode segments 602a-g includes target material. The power supply 608 and the switch 614 control the voltage pulses applied to each of the small circular magnetron cathode segments 602a-g including the target material. The target material from each of the small circular magnetron cathode segments 602a-g sputter coats the substrate. Parameters of the power supply 608, the switch 614, and the magnet assemblies 604a-g, can be changed to adjust the uniformity of the plasma to create customized thickness profiles.

For example, to sputter a thicker coating in the center of the substrate, the switch 614 can route a greater number of voltage pulses to the small circular magnetron cathode segment 602a in the center of the segmented magnetron cathode 602 than to the other small circular magnetron cathode segments 602b-g that surround the center small circular magnetron cathode segment 602a. The switch routing sequence in this example will increase the sputtering rate from the small circular magnetron cathode segment 602a and will increase the thickness of the sputtered film proximate to the center of the substrate. Alternatively, the switch 614 can route voltage pulses having longer pulse widths to the center small circular magnetron cathode segment 602a and voltage pulses having shorter pulse widths to the other small circular magnetron cathode segments 602b-g. Any combination of applying different numbers of voltage pulses and/or voltage pulses having different pulse widths can be used. The switch 614 can route any number of voltage pulses to the various small circular magnetron cathode segments 602a-g.

In addition, the power supply 608 can change the plasma density proximate to the various small circular magnetron cathode segments 602a-g by varying the rise times of the voltage pulses that are applied to the various small circular magnetron cathode segments 602a-g. For example, voltage pulses having very fast rise times that generate higher density plasmas that increase the sputtering rate of the target material can be applied to particular circular magnetron cathode segments 602a-g to change the plasma density distribution.

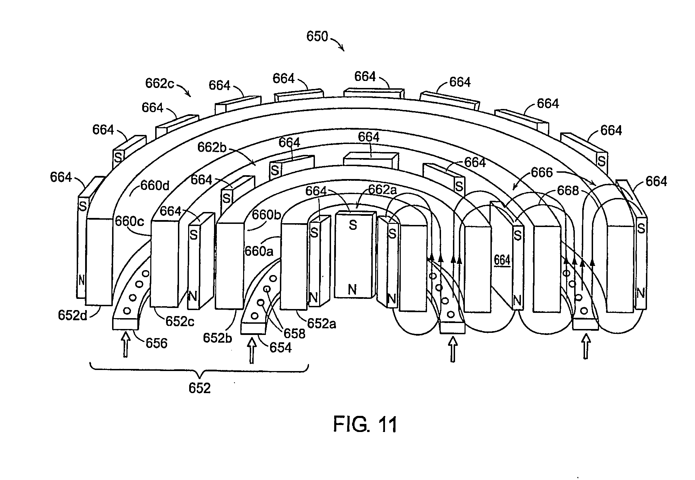

FIG. 11 illustrates a diagram of a plasma source 650 that includes a segmented magnetron cathode 652 having a plurality of concentric magnetron cathode segments 652a-d according to one embodiment of the invention. The concentric magnetron cathode segments 652a-d are configured into multiple isolated hollow cathodes. The plasma source 650 also includes a first 654 and a second anode 656 that are ring-shaped. The anodes 654, 656 can include multiple gas injector ports 658. The gas injector ports 658 supply feed gas between the magnetron cathode segments 652a-d. The pressure of the feed gas can be adjusted to optimize the plasma process. For example, in a reactive sputtering process, feed gas flowing across surfaces 660a-d of the magnetron cathode segments 652a-d can prevent reactive gas from interacting with and damaging the surfaces 660a-d of the magnetron cathode segments 652a-d. In some embodiments, the gas injector ports 658 supply excited atoms such as metastable atoms between the magnetron cathode segments 652a-d. The excited atoms can improve the plasma process by increasing the rate of ionization of the plasma and the density of the plasma.

The segmented magnetron cathode 652 also includes groups 662a-c of magnets 664 that are positioned in rings around each of the magnetron cathode segments 652a-d. Each of the magnets 664 are positioned with their magnetic poles aligned in the same direction. The magnets 664 generate magnetic fields 666 having magnetic field lines 668. The magnetic fields 666 repel each other causing the magnetic field lines 668 to become more parallel to the surfaces of the magnetron cathode segments 652a-d. The parallel magnetic field lines can improve target utilization in sputtering processes in which the magnetron cathode segments 652a-d include target material. The parallel magnetic field lines can also improve ion bombardment of the target material because a substantial portion of the plasma is trapped close to the surfaces of the magnetron cathode segments 652a-d where the target material is located.

In one embodiment, at least two of the magnetron cathode segments 652a-d have different shapes and/or areas that are chosen to improve the uniformity of the coating. Additionally, in one embodiment, at least two of the magnetron cathode segments 652a-d have different target materials that are used in a compound sputtering process. The plasma source 650 can also be used for ionized physical vapor deposition (I-PVD).

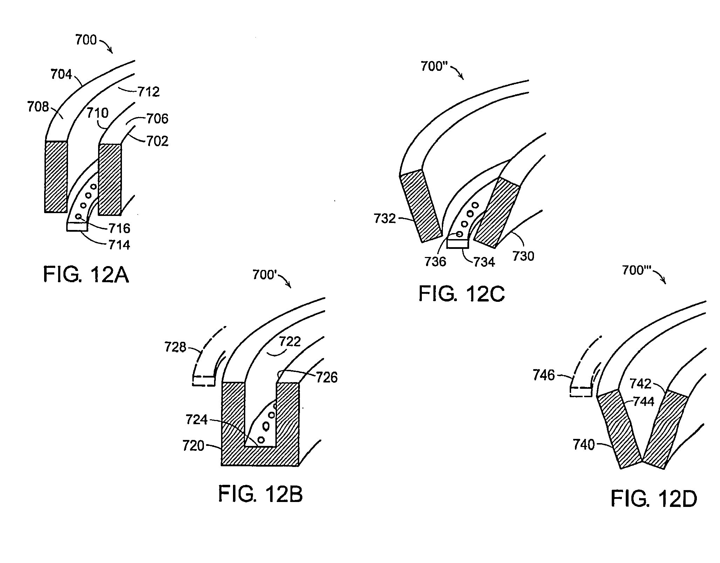

FIGs. 12A-12D illustrate four segmented cathodes 700, 700', 700", 700"' having various shapes according to the invention. The first segmented cathode 700 illustrated in FIG. 12A includes two cathode segments 702, 704 that are substantially parallel to each other. The surfaces 706, 708, 710, and 712 of the segmented cathode 700 can include target material for sputtering. Alternatively, the segmented cathode 700 can each be formed from a target material. An anode 714 is positioned proximate to the segmented cathode 700. A plasma can be ignited by generating a discharge between the anode 714 and the segmented cathode 700. The anode 714 can include one or more gas injector ports 716. The injector ports 716 can supply feed gas between the two cathode segments 702, 704. The injector ports 716 can also supply excited atoms such as metastable atoms between the two cathode segments 702, 704.

FIG. 12B illustrates the second segmented cathode 700'. The second segmented cathode 700' includes a substantially U-shaped cathode segment 720. The U-shaped cathode segment 720 can include target material positioned on each of the inside surfaces 722, 724, 726. In one embodiment, the U-shaped cathode segment 720 is formed from the target material. The U-shaped cathode segment has a larger surface area and provides more target material as compared with the first segmented cathode 700 of FIG. 12A. An anode 728 is positioned proximate to the second segmented cathode 700'. A plasma can be ignited by a discharge between the anode 728 and the second segmented cathode 700'.

FIG. 12C illustrates the third segmented cathode 700". The third segmented cathode 700" is similar to the first segmented cathode 700, except that the two cathode segments 730, 732 are positioned non-parallel relative to each other. The non-parallel configuration can improve a sputtering process by exposing a larger surface area of target material towards the substrate (not shown). An anode 734 is positioned proximate to the segmented cathode 700". A plasma can be ignited by a discharge between the anode 734 and the segmented cathode 700". The anode 734 can include one or more gas injector ports 736 that supply feed gas between the two cathode segments 730, 732.

FIG. 12D illustrates the fourth segmented cathode 700"'. The fourth segmented cathode 700'" is similar to the second segmented cathode 700', except that the cathode segment 740 is substantially V-shaped. The V-shaped cathode segment 740 can include target material on each of the inside surfaces 742, 744. An anode 746 is positioned proximate to the fourth segmented cathode 700"'. A plasma can be ignited by a discharge between the anode 746 and the fourth segmented cathode 700"'.

## Claims

1. A plasma source (100) comprising:
a power supply (128);
a chamber (101) for containing a feed gas;
an anode (104) that is positioned in the chamber;
a segmented magnetron cathode (102) comprising a plurality of magnetron cathode segments (102a-d) that are positioned in the chamber proximate to the anode, each of the plurality of magnetron cathode segments being electrically isolated from each of the other magnetron cathode segments;
**characterised in that** the plasma source further comprises:
a switch (110) having an electrical input (124) and a plurality of electrical outputs (108, 114, 118, 122), a respective one of the plurality of electrical outputs being electrically connected to a respective one of the plurality of magnetron cathode segments; and **in that**
the power supply has an electrical output (126) that is electrically connected to the electrical input (124) of the switch, the power supply being arranged to generate a train of voltage pulses (201-210) that ignites a plasma from the feed gas, individual voltage pulses in the train of voltage pulses being routed by the switch in a predetermined sequence to at least two of the plurality of magnetron cathode segments.

2. The plasma source (100) of claim 1 wherein the anode (104) comprises a plurality of anode sections (104a-d), a respective one of the plurality of anode sections being positioned adjacent to a respective one of the plurality of magnetron cathode segments (102a-d).

3. The plasma source (100) of claim 2 wherein the plurality of magnetron cathode segments (102a-d) and the plurality of anode sections (104a-d) are concentrically positioned.

4. The plasma source (100) of claim 1, 2 or 3 wherein the anode (104) comprises at least one gas injector (658).

5. The plasma source (100) of any preceding claim wherein at least one of the plurality of magnetron cathode segments (102a-d) comprises sputtering target material.

6. The plasma source (100) of any preceding claim wherein at least one of the magnetron cathode segments (102a-d) comprises a target material that is different from a target material of another one of the magnetron cathode segments.

7. The plasma source (100) of any preceding claim wherein the plurality of magnetron cathode segments (102a-d) comprises a hollow cathode magnetron.

8. The plasma source (100) of claim 1 wherein each of the plurality of magnetron cathode segments (102a-d) is positioned in a unique plane parallel to a substrate (141).

9. The plasma source (100) of claim 1 wherein each of the plurality of magnetron cathode segments (102a-d) is positioned in a unique plane perpendicular to a substrate (141).

10. The plasma source (100) of any preceding claim wherein at least two of the plurality of magnetron cathode segments (102a-d) have different dimensions.

11. The plasma source (100) of any preceding claim wherein the switch (110) comprises at least one insulated gate bipolar transistor (IGBT).

12. The plasma source (100) of any preceding claim wherein the power supply (128) generates at least one voltage pulse in the train of voltage pulses (201-210) that comprises a rise time and an amplitude that generates a weakly-ionized plasma having a density of less than 10¹² cm⁻³ and drives the weakly-ionized plasma to a strongly-ionized state having a density of greater than 10¹² cm⁻³ from the feed gas.

13. The plasma source (100) of any preceding claim wherein the power supply (128) generates at least one voltage pulse in the train of voltage pulses (201-210) that comprises a first rise time and a first amplitude that generates a weakly-ionized plasma having a density of less than 10¹² cm⁻³ and a second rise time and a second amplitude that generates a strongly-ionized plasma having a density of greater than 10¹² cm⁻³.

14. The plasma source (100) of claim 13 wherein the power supply (128) generates at least one voltage pulse in the train of voltage pulses (201-210) that comprises a rise time and a peak amplitude that shifts an electron energy distribution in the weakly-ionized plasma to energies that rapidly increase electron density in the weakly-ionized plasma so that a strongly-ionized plasma is formed.

15. The plasma source (100) of any preceding claim wherein the power supply (128) generates at least one voltage pulse in the train of voltage pulses (201-210) that comprises a rise time and an amplitude that generates a strongly-ionized plasma having a density of greater than 10¹² cm⁻³ from the feed gas.

16. The plasma source (100) of any preceding claim further comprising at least two magnets (152) that are positioned proximate to the plurality of magnetron cathode segments (102a-d).

17. The plasma source (100) of claim 16 wherein the at least two magnets (152) generate an unbalanced magnetic field.

18. The plasma source (100) of any preceding claim further comprising a reactive gas source that is coupled to the chamber, the reactive gas source supplying reactive gas to the chamber (101).

19. The plasma source (100) of any preceding claim further comprising an excited atom source that is coupled to the chamber (101), the excited atom source (170) supplying excited atoms (172) to the chamber.

20. The plasma source (100) of claim 19 wherein at least some of the excited atoms (172) supplied by the excited atom source (170) comprise metastable atoms.

21. The plasma source (100) of any preceding claim further comprising a pre-ionizing electrode that is positioned in the chamber, the pre-ionizing electrode generating a weakly- ionized plasma proximate to the segmented magnetron cathode (102).

22. The plasma source (100) of any preceding claim further comprising a controller that is electrically connected to the power supply (128), the controller determining the predetermined pulse sequence of the individual voltage pulses (201-210).

23. A method for generating a plasma, the method comprising:
confining a feed gas; **characterised by**
generating a train of voltage pulses (201-210);
switching said voltage pulses such that a first voltage pulse (201) in the train of voltage pulses is applied to a first magnetron cathode segment (102a) of a segmented magnetron cathode; and
switching said voltage pulses such that a second voltage pulse (202) in the train of voltage pulses is applied to a second magnetron cathode segment (102b) of the segmented magnetron cathode that is electrically isolated from the first magnetron cathode segment, at least one of the first voltage pulse and the second voltage pulse generating a plasma from the feed gas.

24. The method of claim 23 wherein the first and the second voltage pulse (201-210) are not consecutive voltage pulses in the train of voltage pulses.

25. The method of claim 23 or 24 wherein the first voltage pulse (201) in the train of voltage pulses (201-210) ignites a weakly-ionized plasma with a density less than about 10¹² cm⁻³ from the feed gas.

26. The method of claim 25 wherein the applying the second voltage pulse (202) in the train of voltage pulses (201-210) shifts an electron energy distribution in the weakly-ionized plasma to energies that rapidly increase electron density in the weakly-ionized plasma so that a strongly-ionized plasma with a density greater than about 10¹² cm⁻³ is formed.

27. The method of claim 23 wherein the applying the second voltage pulse (202) in the train of voltage pulses (201-210) increases a density of the plasma.

28. The method of any of claims 23 to 27 further comprising generating a magnetic field through the plasma.

29. The method of claim 28 wherein the magnetic field comprises an unbalanced magnetic field.

30. The method of any of claims 23 to 29 further comprising supplying excited atoms (172) proximate to the segmented magnetron cathode (102).

31. The method of claim 30 wherein at least some of the excited atoms (172) comprise metastable atoms.

32. The method of any of claims 23 to 31 further comprising confining a reactive gas and generating the plasma from the reactive gas.

33. The method of any of claims 23 to 32 further comprising combining a reactive gas with the plasma.

34. The method of any of claims 23 to 33 further comprising applying a third voltage pulse (203) in the train of voltage pulses (201-210) to a third magnetron cathode segment (102c) that is electrically isolated from both the first magnetron cathode segment (102a) and the second magnetron cathode segment (102b).

35. The method of any of claims 23 to 34 wherein a shape of the first voltage pulse (201) is different than a shape of the second voltage pulse (202).

36. The method of any of claims 23 to 35 further comprising changing at least one of a rise time, a fall time, an amplitude, a pulse width, and a shape of at least one of the first and the second voltage pulse (201, 202) in order to increase a density of the plasma.

37. A method of generating a uniform coating on a substrate (141), comprising:
generating a plasma from first and second voltage pulses (201, 202) according to claim 23;
the first voltage pulse generating a plasma that sputters target material from the first cathode segment (102a) onto a surface of the substrate;
the second voltage pulse generating a plasma that sputters target material from the second cathode segment (102b) onto the surface of the substrate; and
selecting at lest one of a rise time, a fall time, an amplitude, a shape, and a pulse width of at least one of the first and the second voltage pulses to achieve a desired uniformity of sputtered target material on the surface of the substrate.

## Patentansprüche

1. Plasmaquelle (100), mit:
einer Leistungsquelle (128);
einer Kammer (101), um ein Beschickungsgas zu enthalten;
einer Anode (104), die in der Kammer positioniert ist;
einer segmentierten Magnetronkatode (102), die mehrere Magnetronkatodensegmente (102a-d) aufweist, die in der Kammer in der Nähe der Anode positioniert sind, wobei jedes der mehreren Magnetronkatodensegmente von jedem der anderen Magnetronkatodensegmente elektrisch isoliert ist;
**dadurch gekennzeichnet, dass** die Plasmaquelle ferner enthält:
einen Schalter (110), der einen elektrischen Eingang (124) und mehrere elektrische Ausgänge (108, 114, 118, 122) besitzt, wobei ein Entsprechender bzw. Respektiver der mehreren elektrischen Ausgänge mit einem Entsprechenden bzw. Respektiven der mehreren Magnetronkatodensegmente elektrisch verbunden ist; und dass
die Leistungsquelle einen elektrischen Ausgang (126) besitzt, der mit dem elektrischen Eingang (124) des Schalters elektrisch verbunden ist, wobei die Leistungsquelle dazu ausgelegt ist, einen Zug von Spannungsimpulsen (201-210) zu erzeugen, der ein Plasma aus dem Beschickungsgas zündet, wobei einzelne Spannungsimpulse in dem Zug von Spannungsimpulsen durch den Schalter in einer vorgegebenen Folge zu wenigstens zwei der mehreren Magnetronkatodensegmente gelenkt werden.

2. Plasmaquelle (100) nach Anspruch 1, wobei die Anode (104) mehrere Anodenabschnitte (104a-d) aufweist, wobei ein Entsprechender der mehreren Anodenabschnitte benachbart zu einem Entsprechenden der mehreren Magnetronkatodensegmente (102a-d) positioniert ist.

3. Plasmaquelle (100) nach Anspruch 2, wobei die mehreren Magnetronkatodensegmente (102a-d) und die mehreren Anodenabschnitte (104a-d) konzentrisch positioniert sind.

4. Plasmaquelle (100) nach Anspruch 1, 2 oder 3, wobei die Anode (104) wenigstens einen Gasinjektor (658) aufweist.

5. Plasmaquelle (100) nach einem vorhergehenden Anspruch, wobei wenigstens eines der mehreren Magnetronkatodensegmente (102a-d) ein Sputter-Targetmaterial enthält.

6. Plasmaquelle (100) nach einem vorhergehenden Anspruch, wobei wenigstens eines der Magnetronkatodensegmente (102a-d) ein Targetmaterial enthält, das von einem Targetmaterial eines Weiteren der Magnetronkatodensegmente verschieden ist.

7. Plasmaquelle (100) nach einem vorhergehenden Anspruch, wobei die mehreren Magnetronkatodensegmente (102a-d) ein hohles Katodenmagnetron aufweisen.

8. Plasmaquelle (100) nach Anspruch 1, wobei jedes der mehreren Magnetronkatodensegmente (102a-d) in einer eindeutigen Ebene parallel zu einem Substrat (141) positioniert ist.

9. Plasmaquelle (100) nach Anspruch 1, wobei jedes der mehreren Magnetronkatodensegmente (102a-d) in einer eindeutigen Ebene senkrecht zu einem Substrat (141) positioniert ist.

10. Plasmaquelle (100) nach einem vorhergehenden Anspruch, wobei wenigstens zwei der mehreren Magnetronkatodensegmente (102a-d) verschiedene Abmessungen haben.

11. Plasmaquelle (100) nach einem vorhergehenden Anspruch, wobei der Schalter (110) wenigstens einen Bipolartransistor mit isoliertem Gate (IGBT) aufweist.

12. Plasmaquelle (100) nach einem vorhergehenden Anspruch, wobei die Leistungsquelle (128) wenigstens einen Spannungsimpuls in dem Zug von Spannungsimpulsen (201-210) erzeugt, der eine Anstiegszeit und eine Amplitude aufweist, die ein schwach ionisiertes Plasma mit einer Dichte von weniger als 10¹² cm⁻³ erzeugt und das schwach ionisierte Plasma von dem Beschickungsgas in einen stark ionisierten Zustand mit einer Dichte von mehr als 10¹² cm⁻³ drängt.

13. Plasmaquelle (100) nach einem vorhergehenden Anspruch, wobei die Leistungsquelle (128) wenigstens einen Spannungsimpuls in dem Zug von Spannungsimpulsen (201-210) erzeugt, der eine erste Anstiegszeit und eine erste Amplitude, die ein schwach ionisiertes Plasma mit einer Dichte von weniger als 101² cm⁻³ erzeugt, und eine zweite Anstiegszeit und eine zweite Amplitude, die ein stark ionisiertes Plasma mit einer Dichte von mehr als 10¹² cm⁻³ erzeugt, aufweist.

14. Plasmaquelle (100) nach Anspruch 13, wobei die Leistungsversorgung (128) wenigstens einen Spannungsimpuls in dem Zug von Spannungsimpulsen (201-210) erzeugt, der eine Anstiegszeit und eine Spitzenamplitude aufweist, die eine Elektronenenergieverteilung in dem schwach ionisierten Plasma zu Energien verschiebt, die die Elektronendichte in dem schwach ionisierten Plasma schnell erhöhen, so dass ein stark ionisiertes Plasma gebildet wird.

15. Plasmaquelle (100) nach einem vorhergehenden Anspruch, wobei die Leistungsversorgung (128) wenigstens einen Spannungsimpuls in dem Zug von Spannungsimpulsen (201-210) erzeugt, der eine Anstiegszeit und eine Amplitude, die aus dem Beschickungsgas ein stark ionisiertes Plasma mit einer Dichte von mehr als 10¹² cm⁻³ erzeugt, aufweist.

16. Plasmaquelle (100) nach einem vorhergehenden Anspruch, die ferner wenigstens zwei Magneten (152) aufweist, die in der Nähe der mehreren Magnetronkatodensegmente (102a-d) positioniert sind.

17. Plasmaquelle (100) nach Anspruch 16, wobei die wenigstens zwei Magneten (152) ein nicht im Gleichgewicht befindliches Magnetfeld erzeugen.

18. Plasmaquelle (100) nach einem vorhergehenden Anspruch, die ferner eine Quelle für reaktives Gas enthält, die mit der Kammer gekoppelt ist, wobei die Quelle für reaktives Gas der Kammer (101) reaktives Gas zuführt.

19. Plasmaquelle (100) nach einem vorhergehenden Anspruch, ferner mit einer Quelle für angeregte Atome, die mit der Kammer (101) gekoppelt ist, wobei die Quelle (170) für angeregte Atome der Kammer angeregte Atome (172) zuführt.

20. Plasmaquelle (100) nach Anspruch 19, wobei wenigstens einige der angeregten Atome (172), die von der Quelle (170) für angeregte Atome zugeführt werden, metastabile Atome enthalten.

21. Plasmaquelle (100) nach einem vorhergehenden Anspruch, ferner mit einer vorionisierten Elektrode, die in der Kammer positioniert ist, wobei die vorionisierte Elektrode in der Nähe der segmentierten Magnetronkatode (102) ein schwach ionisiertes Plasma erzeugt.

22. Plasmaquelle (100) nach einem vorhergehenden Anspruch, ferner mit einer Steuereinheit, die mit der Leistungsversorgung (128) elektrisch verbunden ist, wobei die Steuereinheit die vorgegebene Impulsfolge der einzelnen Spannungsimpulse (201-210) bestimmt.

23. Verfahren zum Erzeugen eines Plasmas, wobei das Verfahren Folgendes umfasst:
Einschließen eines Beschickungsgases; **gekennzeichnet durch**
Erzeugen eines Zugs von Spannungsimpulsen (201-210);
Schalten der Spannungsimpulse in der Weise, dass ein erster Spannungsimpuls (210) in dem Zug von Spannungsimpulsen an ein erstes Magnetronkatodensegment (102a) einer segmentierten Magnetronkatode angelegt wird; und
Schalten der Spannungsimpulse in der Weise, dass ein zweiter Spannungsimpuls (202) in dem Zug von Spannungsimpulsen an ein zweites Magnetronkatodensegment (102b) der segmentierten Magnetronkatode, das von dem ersten Magnetronkatodensegment elektrisch isoliert ist, angelegt wird, wobei der erste Spannungsimpuls und/oder der zweite Spannungsimpuls aus dem Beschickungsgas ein Plasma erzeugen.

24. Verfahren nach Anspruch 23, wobei der erste und der zweite Spannungsimpuls (201-210) keine aufeinander folgenden Spannungsimpulse in dem Zug von Spannungsimpulsen sind.

25. Verfahren nach Anspruch 23 oder 24, wobei der erste Spannungsimpuls (201) in dem Zug von Spannungsimpulsen (201-210) ein schwach ionisiertes Plasma mit einer Dichte von weniger als etwa 10¹² cm⁻³ von dem Beschickungsgas zündet.

26. Verfahren nach Anspruch 25, wobei das Anlegen des zweiten Spannungsimpulses (202) in dem Zug von Spannungsimpulsen (201-210) eine Elektronenenergieverteilung in dem schwach ionisierten Plasma zu Energien verschiebt, die die Elektronendichte in dem schwach ionisierten Plasma schnell erhöhen, so dass ein stark ionisiertes Plasma mit einer Dichte von mehr als etwa 10¹² cm⁻³ gebildet wird.

27. Verfahren nach Anspruch 23, wobei das Anlegen des zweiten Spannungsimpulses (202) in dem Zug von Spannungsimpulsen (201-210) die Dichte des Plasmas erhöht.

28. Verfahren nach einem der Ansprüche 23 bis 27, das ferner das Erzeugen eines Magnetfeldes durch das Plasma umfasst.

29. Verfahren nach Anspruch 28, wobei das Magnetfeld ein nicht im Gleichgewicht befindliches Magnetfeld aufweist.

30. Verfahren nach einem der Ansprüche 23 bis 29, das ferner das Zuführen von angeregten Atomen (172) in die Umgebung der segmentierten Magnetronkatode (102) umfasst.

31. Verfahren nach Anspruch 30, wobei wenigstens einige der angeregten Atome (172) metastabile Atome enthalten.

32. Verfahren nach einem der Ansprüche 23 bis 31, das ferner das Einschließen eines reaktiven Gases und das Erzeugen des Plasmas aus dem reaktiven Gas umfasst.

33. Verfahren nach einem der Ansprüche 23 bis 32, das ferner das Kombinieren eines reaktiven Gases mit dem Plasma umfasst.

34. Verfahren nach einem der Ansprüche 23 bis 33, das ferner das Anlegen eines dritten Spannungsimpulses (203) in dem Zug von Spannungsimpulsen (201-210) an ein drittes Magnetronkatodensegment (102c), das sowohl von dem ersten Magnetronkatodensegment (102a) als auch von dem zweiten Magnetronkatodensegment (102b) elektrisch isoliert ist, umfasst.

35. Verfahren nach einem der Ansprüche 23 bis 34, wobei eine Form des ersten Spannungsimpulses (201) von einer Form des zweiten Spannungsimpulses (202) verschieden ist.

36. Verfahren nach einem der Ansprüche 23 bis 35, das ferner das Verändern einer Anstiegszeit und/oder einer Abfallzeit und/oder einer Amplitude und/oder einer Impulsbreite und/oder einer Form des ersten und/oder des zweiten Spannungsimpulses (201, 202), um eine Dichte des Plasmas zu erhöhen, umfasst.

37. Verfahren zum Erzeugen einer gleichmäßigen Beschichtung auf einem Substrat (141), das umfasst:
Erzeugen eines Plasmas von dem ersten und dem zweiten Spannungsimpuls (201, 202) nach Anspruch 23;
wobei der erste Spannungsimpuls ein Plasma erzeugt, das Targetmaterial von dem ersten Katodensegment (102a) auf eine Oberfläche des Substrats sputtert;
wobei der zweite Spannungsimpuls ein Plasma erzeugt, das Targetmaterial von dem zweiten Katodensegment (102b) auf die Oberfläche des Substrats sputtert; und
Auswählen einer Anstiegszeit und/oder einer Abfallzeit und/oder einer Amplitude und/oder einer Form und/oder einer Impulsbreite des ersten und/oder des zweiten Spannungsimpulses, um eine gewünschte Gleichmäßigkeit von gesputtertem Targetmaterial auf der Oberfläche des Substrats zu erzielen.

## Revendications

1. Source de plasma (100) comportant :
une alimentation en courant (128) ;
une chambre (101) pour contenir un gaz d'alimentation ;
une anode (104) qui est positionnée dans la chambre ;
une cathode de magnétron segmentée (102) comportant une pluralité de segments de cathode de magnétron (102a à 102d) qui sont positionnés dans la chambre à proximité de l'anode, chaque segment de la pluralité de segments de cathode de magnétron étant électriquement isolé de chacun des autres segments de cathode de magnétron ;
**caractérisée en ce que** la source de plasma comporte en outre :
un commutateur (110) ayant une entrée électrique (124) et une pluralité de sorties électriques (108, 114, 118, 122), une sortie respective de la pluralité de sorties électriques étant électriquement reliée à un segment respectif de la pluralité de segments de cathode de magnétron ; et **en ce que**
l'alimentation en courant a une sortie électrique (126) qui est électriquement reliée à l'entrée électrique (124) du commutateur, l'alimentation en courant étant conçue pour générer un train d'impulsions de tension (201 à 210) qui amorce un plasma à partir du gaz d'alimentation, des impulsions de tension individuelles dans le train d'impulsions de tension étant acheminées par le commutateur dans une séquence prédéterminée jusqu'à au moins deux segments de la pluralité de segments de cathode de magnétron.

2. Source de plasma (100) selon la revendication 1, dans laquelle l'anode (104) comporte une pluralité de parties d'anode (104a à 104d), une partie respective de la pluralité de parties d'anode étant positionnée adjacente à un segment respectif de la pluralité de segments de cathode de magnétron (102a à 102d).

3. Source de plasma (100) selon la revendication 2, dans laquelle la pluralité de segments de cathode de magnétron (102a à 102d) et la pluralité de parties d'anode (104a à 104d) sont positionnés de manière concentrique.

4. Source de plasma (100) selon la revendication 1, 2 ou 3, dans laquelle l'anode (104) comporte au moins un injecteur de gaz (658).

5. Source de plasma (100) selon l'une quelconque des revendications précédentes, dans laquelle au moins un segment de la pluralité de segments de cathode de magnétron (102a à 102d) comporte un matériau de cible de pulvérisation.

6. Source de plasma (100) selon l'une quelconque des revendications précédentes, dans laquelle au moins un des segments de cathode de magnétron (102a à 102d) comporte un matériau de cible qui est différent d'un matériau de cible d'un autre des segments de cathode de magnétron.

7. Source de plasma (100) selon l'une quelconque des revendications précédentes, dans laquelle la pluralité de segments de cathode de magnétron (102a à 102d) comporte un magnétron à cathode creuse.

8. Source de plasma (100) selon la revendication 1, dans laquelle chaque segment de la pluralité de segments de cathode de magnétron (102a à 102d) est positionné dans un plan unique parallèle à un substrat (141).

9. Source de plasma (100) selon la revendication 1, dans laquelle chaque segment de la pluralité de segments de cathode de magnétron (102a à 102d) est positionné dans un plan unique perpendiculaire à un substrat (141).

10. Source de plasma (100) selon l'une quelconque des revendications précédentes, dans laquelle au moins deux segments de la pluralité de segments de cathode de magnétron (102a à 102d) ont différentes dimensions.

11. Source de plasma (100) selon l'une quelconque des revendications précédentes, dans laquelle le commutateur (110) comporte au moins un transistor bipolaire à porte isolée (IGBT).

12. Source de plasma (100) selon l'une quelconque des revendications précédentes, dans laquelle l'alimentation en courant (128) génère au moins une impulsion de tension dans le train d'impulsions de tension (201 à 210) qui comporte un temps de montée et une amplitude qui génère un plasma faiblement ionisé ayant une densité inférieure à 10¹² cm⁻³, et attaque le plasma faiblement ionisé jusqu'à un état fortement ionisé ayant une densité supérieure à 10¹² cm⁻³ à partir du gaz d'alimentation.

13. Source de plasma (100) selon l'une quelconque des revendications précédentes, dans laquelle l'alimentation en courant (128) génère au moins une impulsion de tension dans le train d'impulsions de tension (201 à 210) qui comporte un premier temps de montée et une première amplitude qui génère un plasma faiblement ionisé ayant densité inférieure à 10¹² cm⁻³ et un second temps de montée et une seconde amplitude qui génère un plasma fortement ionisé ayant une densité supérieure à 10¹² cm⁻³.

14. Source de plasma (100) selon la revendication 13, dans laquelle l'alimentation en courant (128) génère au moins une impulsion de tension dans le train d'impulsions de tension (201 à 210) qui comporte un temps de montée et une amplitude maximale qui décale une répartition d'énergie d'électrons dans le plasma faiblement ionisé vers des énergies qui augmentent rapidement la densité d'électrons dans le plasma faiblement ionisé de telle sorte qu'un plasma fortement ionisé est formé.

15. Source de plasma (100) selon l'une quelconque des revendications précédentes, dans laquelle l'alimentation en courant (128) génère au moins une impulsion de tension dans le train d'impulsions de tension (201 à 210) qui comporte un temps de montée et une amplitude qui génère un plasma fortement ionisé ayant une densité supérieure à 10¹² cm⁻³ à partir du gaz d'alimentation.

16. Source de plasma (100) selon l'une quelconque des revendications précédentes, comportant en outre au moins deux aimants (152) qui sont positionnés à proximité de la pluralité de segments de cathode de magnétron (102a à 102d).

17. Source de plasma (100) selon la revendication 16, dans laquelle les au moins deux aimants (152) génèrent un champ magnétique non équilibré.

18. Source de plasma (100) selon l'une quelconque des revendications précédentes, comportant en outre une source de gaz réactif qui est couplée à la chambre, la source de gaz réactif délivrant du gaz réactif à la chambre (101).

19. Source de plasma (100) selon l'une quelconque des revendications précédentes, comportant également une source d'atomes excités qui est couplée à la chambre (101), la source d'atomes excités (170) délivrant des atomes excités (172) à la chambre.

20. Source de plasma (100) selon la revendication 19, dans laquelle au moins certains des atomes excités (172) délivrés par la source d'atomes excités (170) comportent des atomes métastables.

21. Source de plasma (100) selon l'une quelconque des revendications précédentes, comportant en outre une électrode de pré-ionisation qui est positionnée dans la chambre, l'électrode de pré-ionisation générant un plasma faiblement ionisé à proximité de la cathode de magnétron segmentée (102).

22. Source de plasma (100) selon l'une quelconque des revendications précédentes, comportant également une commande qui est électriquement reliée à l'alimentation en courant (128), la commande déterminant la séquence d'impulsions prédéterminée des impulsions de tension individuelles (201 à 210).

23. Procédé pour générer un plasma, le procédé comportant l'étape consistant à :
confiner un gaz d'alimentation ; **caractérisé par** les étapes consistant à :
générer un train d'impulsions de tension (201 à 210) ;
commuter lesdites impulsions de tension de telle sorte qu'une première impulsion de tension (201) dans le train d'impulsions de tension est appliquée à un premier segment de cathode de magnétron (102a) d'une cathode de magnétron segmentée ; et
commuter lesdites impulsions de tension de telle sorte qu'une deuxième impulsion de tension (202) dans le train d'impulsions de tension est appliquée à un second segment de cathode de magnétron (102b) de la cathode de magnétron segmentée qui est électriquement isolé du premier segment de cathode de magnétron, au moins une parmi la première impulsion de tension et la deuxième impulsion de tension générant un plasma à partir du gaz d'alimentation.

24. Procédé selon la revendication 23, dans lequel les première et deuxième impulsions de tension (201 à 210) ne sont pas des impulsions de tension consécutives dans le train d'impulsions de tension.

25. Procédé selon la revendication 23 ou 24, dans lequel la première impulsion de tension (201) dans le train d'impulsions de tension (201 à 210) amorce un plasma faiblement ionisé avec une densité inférieure à environ 10¹² cm⁻³ à partir du gaz d'alimentation.

26. Procédé selon la revendication 25, dans lequel l'application de la deuxième impulsion de tension (202) dans le train d'impulsions de tension (201 à 210) décale une répartition d'énergie d'électrons dans le plasma faiblement ionisé vers des énergies qui augmentent rapidement la densité d'électrons dans le plasma faiblement ionisé de telle sorte qu'un plasma fortement ionisé avec une densité supérieure à environ 10¹² cm⁻³ est formé.

27. Procédé selon la revendication 23, dans lequel l'application de la deuxième impulsion de tension (202) dans le train d'impulsions de tension (201 à 210) augmente une densité du plasma.

28. Procédé selon l'une quelconque des revendications 23 à 27, comportant en outre la génération d'un champ magnétique à travers le plasma.

29. Procédé selon la revendication 28, dans lequel le champ magnétique comporte un champ magnétique non équilibré.

30. Procédé selon l'une quelconque des revendications 23 à 29, comportant en outre la fourniture d'atomes excités (172) à proximité de la cathode de magnétron segmentée (102).

31. Procédé selon la revendication 30, dans lequel au moins certains des atomes excités (172) comportent des atomes métastables.

32. Procédé selon l'une quelconque des revendications 23 à 31, comportant en outre le confinement d'un gaz réactif et la génération du plasma à partir du gaz réactif.

33. Procédé selon l'une quelconque des revendications 23 à 32, comportant également la combinaison d'un gaz réactif avec le plasma.

34. Procédé selon l'une quelconque des revendications 23 à 33, comportant de plus l'application d'une troisième impulsion de tension (203) dans le train d'impulsions de tension (201 à 210) à un troisième segment de cathode de magnétron (102c) qui est électriquement isolé à la fois du premier segment de cathode de magnétron (102a) et du deuxième segment de cathode de magnétron (102b).

35. Procédé selon l'une quelconque des revendications 23 à 34, dans lequel une forme de la première impulsion de tension (201) est différente d'une forme de la deuxième impulsion de tension (202).

36. Procédé selon l'une quelconque des revendications 23 à 35, comportant en outre la variation d'au moins un élément parmi un temps de montée, un temps de descente, une amplitude, une largeur d'impulsion et une forme d'au moins une parmi les première et deuxième impulsions de tension (201, 202) afin d'augmenter une densité du plasma.

37. Procédé de génération d'un revêtement uniforme sur un substrat (141), comportant les étapes consistant à :
générer un plasma à partir de première et deuxième impulsions de tension (201, 202) selon la revendication 23 ;
la première impulsion de tension générant un plasma qui pulvérise un matériau de cible à partir du premier segment de cathode (102a) sur une surface du substrat ;
la deuxième impulsion de tension générant un plasma qui pulvérise un matériau de cible à partir du second segment de cathode (102b) sur la surface du substrat ; et
sélectionner au moins un élément parmi un temps de montée, un temps de descente, une amplitude, une forme et une largeur d'impulsion d'au moins une parmi les première et deuxième impulsions de tension pour obtenir une uniformité désirée du matériau de cible pulvérisé sur la surface du substrat.
